# EUROPEAN PATENT APPLICATION

(11) **EP 4 741 408 A1**
(43) Date of publication of application: **13.05.2026**
(21) Application number: 23947384.6
(22) Date of filing: 04.12.2023
(51) Int. Cl.: C07F 15/00, C09K 11/06, H10K 85/30, H10K 50/11

(54) **TETRADENTATE CYCLOMETALATED PLATINUM (II) COMPLEX BASED ON PYRIDYLCARBAZOLE AND APPLICATION THEREOF, AND ELECTRONIC DEVICE**

(30) Priority: 03.08.2023 CN 202310973492
(71) Applicant: Zhejiang University of Technology, Hangzhou, Zhejiang 310014 (CN); Zhejiang Huaxian Photoelectricity Technology Co., Ltd, Jiaxing, Zhejiang 314107 (CN)
(72) Inventor: LI, Guijie, Hangzhou, Zhejiang 310014 (CN); LU, Yunqi, Hangzhou, Zhejiang 310014 (CN); ZHENG, Jianbing, Hangzhou, Zhejiang 310014 (CN); SHE, Yuanbin, Hangzhou, Zhejiang 310014 (CN); WU, Kongwu, Jiaxing, Zhejiang 314107 (CN)
(74) Representative: Chung, Hoi Kan
(86) International application number: PCT/CN2023/136015
(87) International publication number: WO 2025/025446

(57) **Abstract**

The present invention belongs to the field of organic electroluminescence, and specifically relates to a tetradentate cyclometalated platinum (II) complex based on pyridylcarbazole and an application thereof, and an electronic device. In the present invention, a charge distribution in an excited state of a compound is improved by means of introducing a substituent group at an appropriate position of a ligand of the compound, such that there are more metal-to-pyridocarbene charge transfer states (³MLCT) in an excited state of a material composed of the compound, which is conductive to improving a radiation rate, thereby extending the service life of a device. The material provided has good chemical stability and thermal stability, and is easily prepared into evaporated OLED devices. An organic electroluminescent device manufactured by using the compound of the present invention as a light-emitting layer has significantly improved current efficiency and service 1ife and a significantly reduced tum-on voltage. After the compound is combined with a fluorescent doped material (a boron-containing compound), transmissions of holes and electrons can be balanced, such that energy transfer between a host and a guest is more efficient, and the light color purity of a device can be improved.

## Description

### TECHNICAL FIELD

The present disclosure relates to the field of organic electroluminescence, specifically to a tetradentate cyclometalated platinum(II) complex based on pyridyl-carbazole, an electronic device, and an application thereof.

### BACKGROUND

Organic light-emitting diodes (OLEDs) represent a new generation of full-color display and lighting technology. Compared to the liquid crystal display which suffers from slow response, narrow viewing angle, need for backlight and high energy consumption, OLEDs as self-luminous devices offer advantages such as no requirement for backlight, high energy efficiency, low drive voltage, quick response, high resolution and contrast, wide viewing angle and excellent low-temperature performance; and OLED devices may be fabricated to be thin and into flexible structures. In addition, OLEDs further offer advantages such as low production cost, simple manufacturing process and suitability for large-format products. Therefore, OLEDs possess broad and significant application prospects in high-end electronic products and the aerospace fields. With a gradual increase in investment, further in-depth research and development and upgrading of production equipment, OLEDs will have extensive application scenarios and promising development potential in the future.

The core of the development of OLEDs lies in design and development of light-emitting materials. At present, light-emitting layers of OLED devices in use almost exclusively employs a host-guest light-emitting system, i.e., doping a host material with a guest light-emitting material. An energy gap of the host material is typically higher than that of the guest light-emitting material, such that energy is transferred from the host material to the guest light-emitting material, thereby leading to excitation and subsequent light emission of the guest light-emitting material. Common organic phosphorescent guest materials are predominantly complexes of heavy metals such as iridium(III), platinum(II) and palladium (Pd) (II). Commonly used phosphorescent organic materials 3,3'-bis(9-carbazolyl)-biphenyl (i.e., mCBP) and 2,6-bis(9-carbazolyl)-pyridine (i.e., 2,6-mCPy) possess high efficiency and high triplet energy levels, and when the materials are used as organic materials, triplet energy can be effectively transferred from the light-emitting organic materials to guest phosphorescent materials. However, mCBP exhibits high hole mobility but poor electron transport capability, and 2,6-mCPy suffers from inadequate hole transport. This causes charges in the light-emitting layers to be unbalanced, resulting in a decrease in current efficiency of devices. Moreover, heavy-metal phosphorescent organic complexes in use are mainly cyclometalated iridium(III) complex molecules, whose variety is limited. The abundance of platinum in the Earth's crust and the annual global production of platinum are both approximately ten times greater than those of iridium; and the price of IrCl₃·H₂O used for preparing iridium(III) complex phosphorescent materials is significantly higher than that of PtCl₂ used for preparing platinum(II) complex phosphorescent materials. Additionally, the preparation of the iridium(III) phosphorescent materials involves four steps: preparation of an iridium(III) dimer, ligand exchange of an iridium (III) intermediate, synthesis of a *mer*-iridium(III) complex, and isomerization from mer- to *fac*-iridium(III) complex. This substantially reduces an overall yield, greatly decreases utilization ratio of a starting material IrCl₃·H₂O, and consequently increases a production cost of the iridium(III) phosphorescent materials. In contrast, the preparation of the platinum(II) complex phosphorescent materials consists of just one step: ligand metallation. This process affords a high utilization ratio of platinum, thereby further reducing a production cost of the platinum(II) complex phosphorescent materials. In summary, the production cost of the platinum (II) complex phosphorescent materials is much lower than that of the iridium (III) complex phosphorescent materials. However, there are still some technical challenges in the development of the platinum complex materials and devices, and improving device efficiency and lifetime remains an important research topic. Therefore, novel phosphorescent platinum(II) metal complexes need to be developed.

### SUMMARY

In view of the above, the present disclosure aims to provide a tetradentate cyclometalated platinum(II) complex based on pyridyl-carbazole, an electronic device, and an application thereof. When used as a guest phosphorescent material of a light-emitting layer, the tetradentate cyclometalated platinum(II) complex based on pyridyl-carbazole in the present disclosure may enable a device to exhibit excellent performance, current efficiency of an organic electroluminescent device may be enhanced, lifetime of the device may be improved, and an operating voltage of the device may also be reduced.

To achieve the above-described technical objective, the technical solutions of the present disclosure are as described below.

The present disclosure provides a tetradentate cyclometalated platinum(II) complex based on pyridyl-carbazole. The complex has a structure as shown in formula (I):

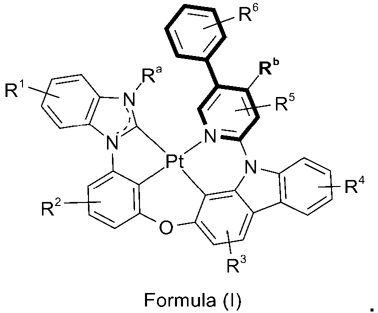

In formula (I), R¹-R⁶ each independently represent from mono to maximum allowable substitution, or no substitution; R¹-R⁶ are each independently selected from the group consisting of: hydrogen, deuterium (D), halogen, C1-C30 alkyl, C1-C30 haloalkyl, substituted or unsubstituted C6-C60 aryl, and combinations thereof; and

R^{a} and R^{b} are each independently selected from the group consisting of: hydrogen, deuterium, C1-C30 alkyl, substituted or unsubstituted C6-C60 aryl, and combinations thereof; and a substituent on each substituted C6-C60 aryl is deuterium, C1-C30 alkyl or C6-C60 aryl.

Furthermore, R^{a} is selected from hydrogen, deuterium, CD₃, C1-C10 alkyl, C6-C30 aryl, and combinations thereof. R^{b} is selected from hydrogen, deuterium, C1-C20 alkyl, and combinations thereof.

Furthermore, R¹-R⁶ are each independently selected from hydrogen, deuterium, CD₃, F, CF₃, methyl, ethyl, propyl, isopropyl, butyl, tert-butyl, pentyl, hexyl, heptyl, phenyl, and combinations thereof.

Preferably, the tetradentate cyclometalated platinum(II) complex based on pyridyl-carbazole is any one selected from chemical structures shown below, wherein D represents deuterium:

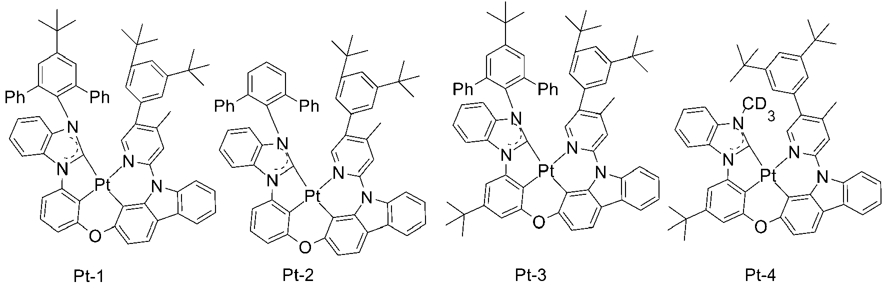

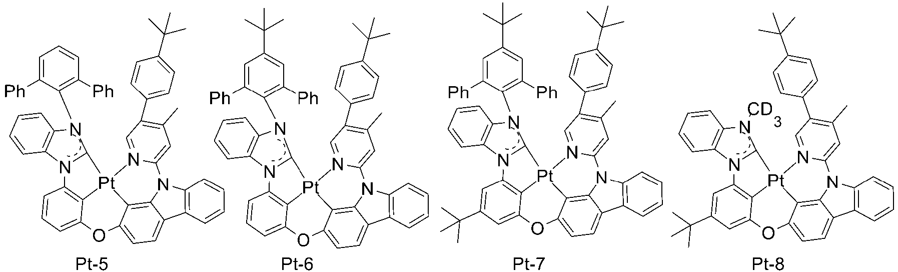

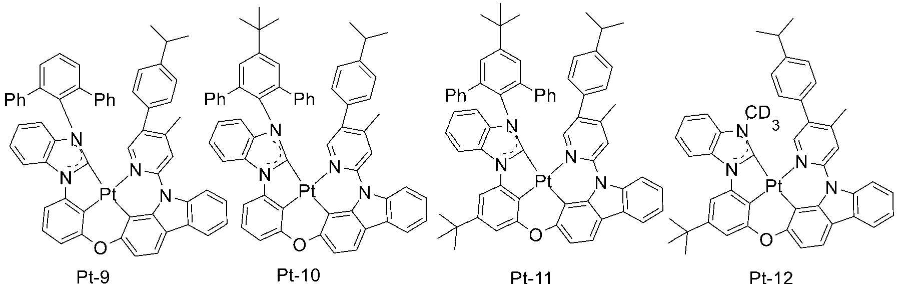

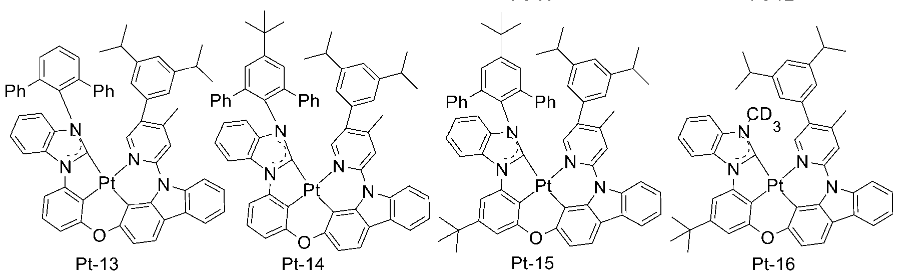

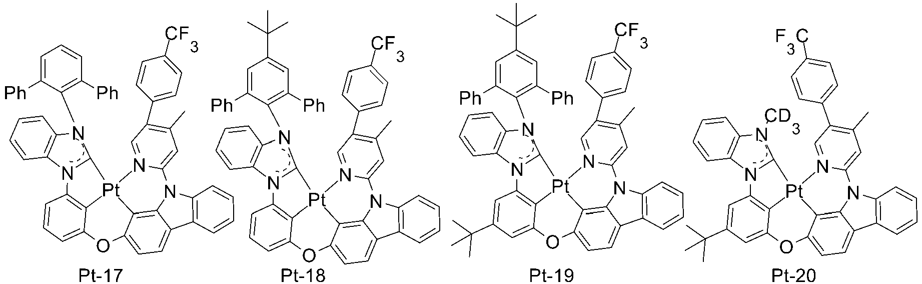

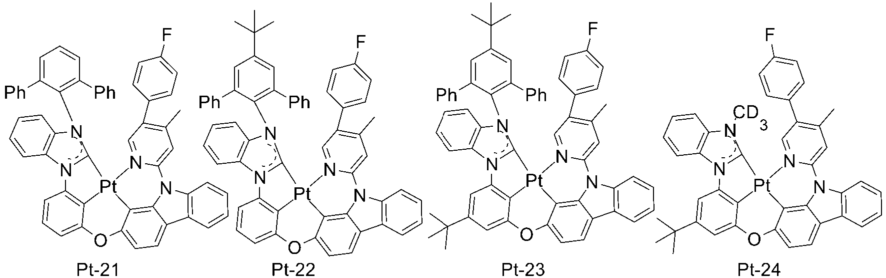

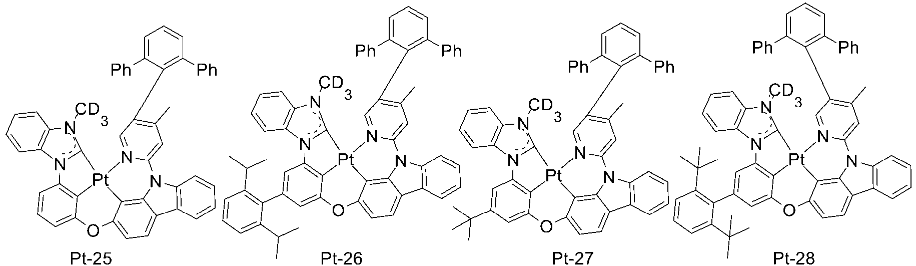

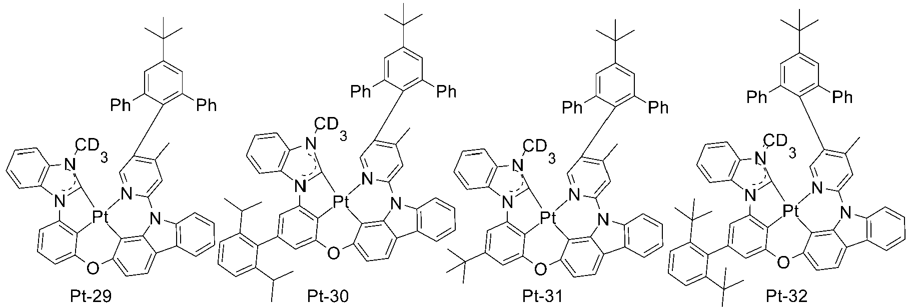

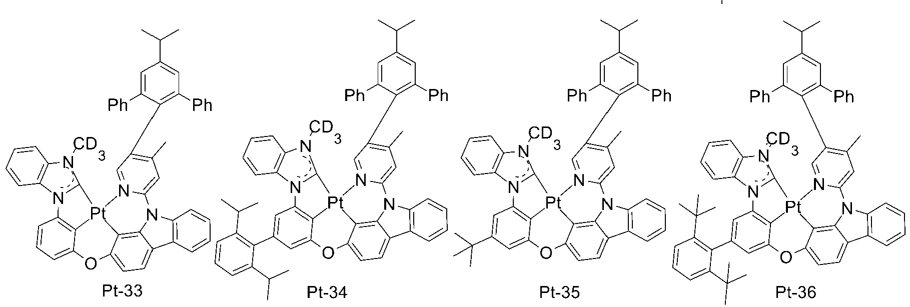

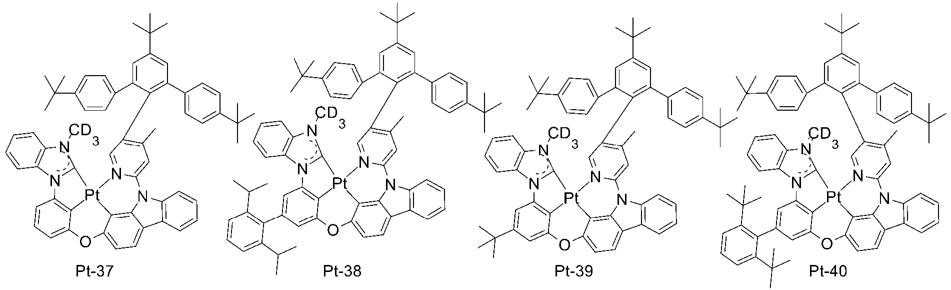

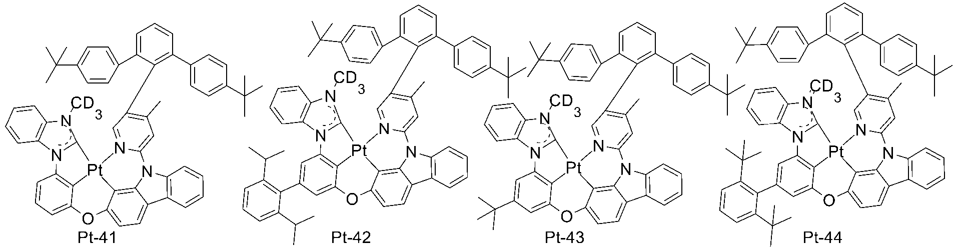

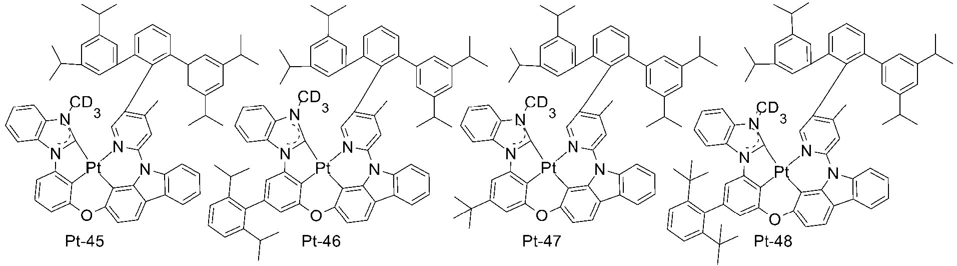

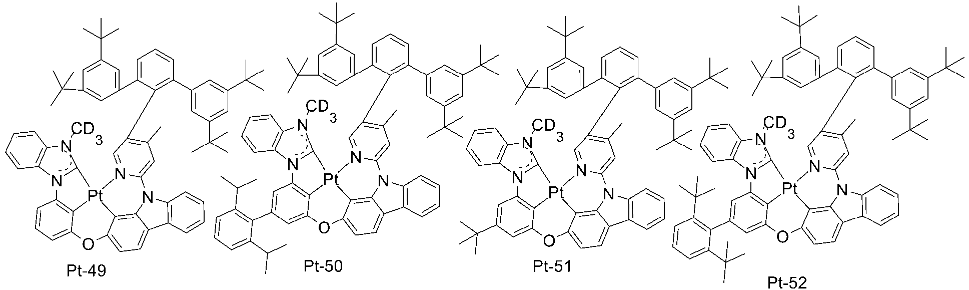

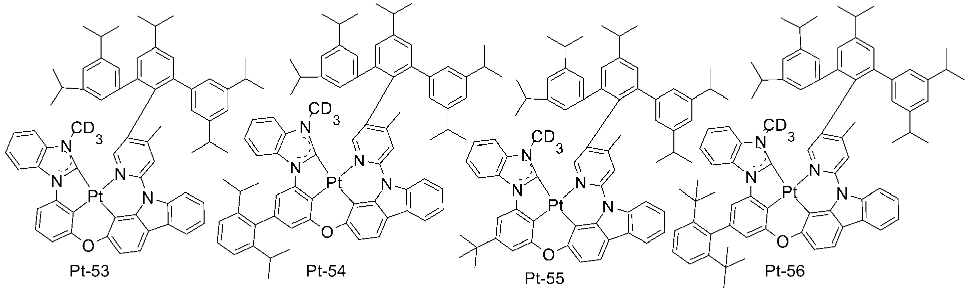

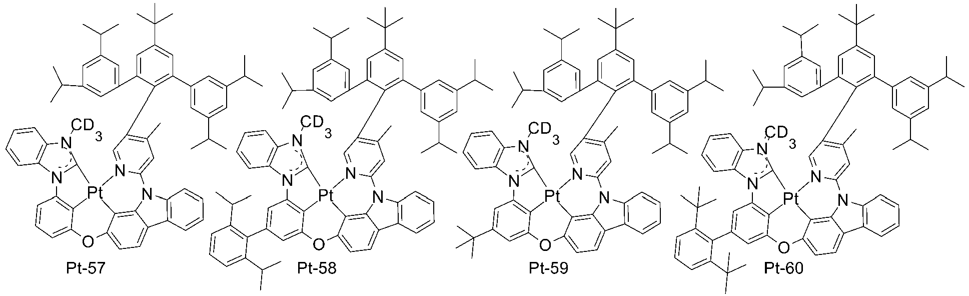

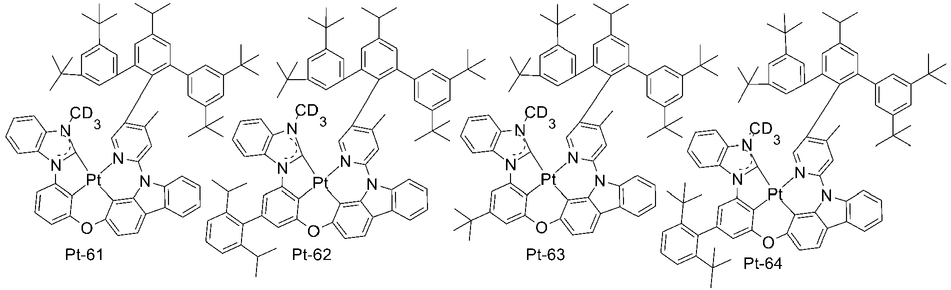

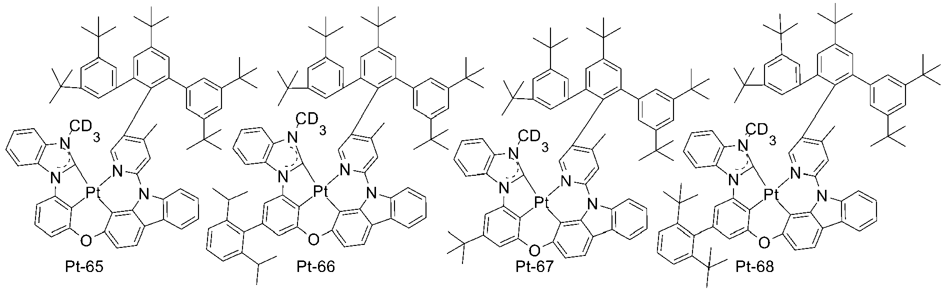

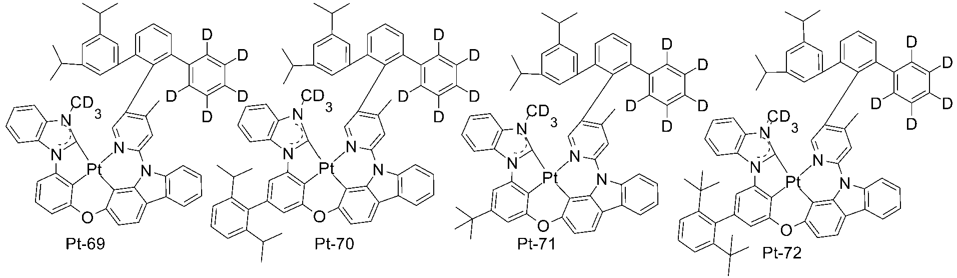

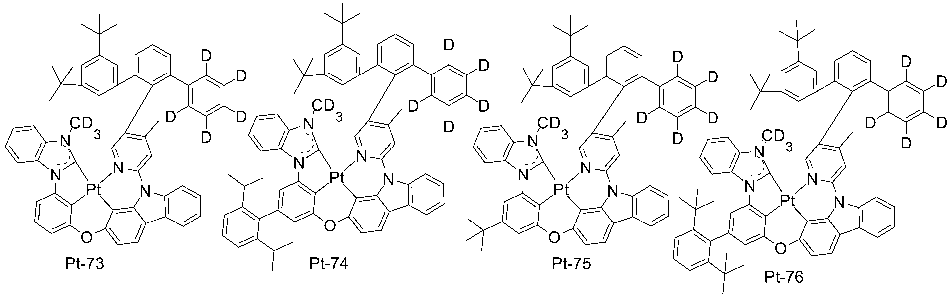

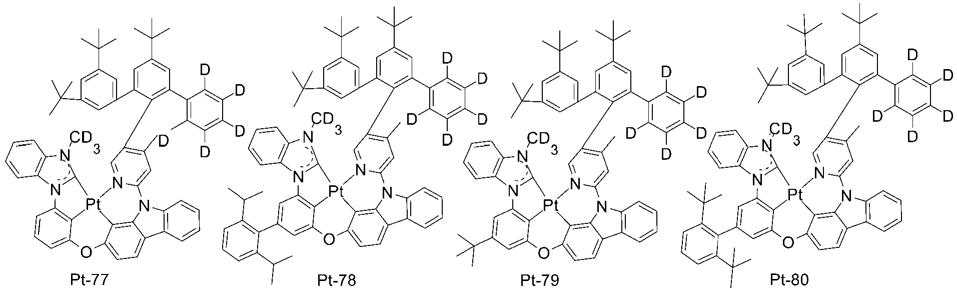

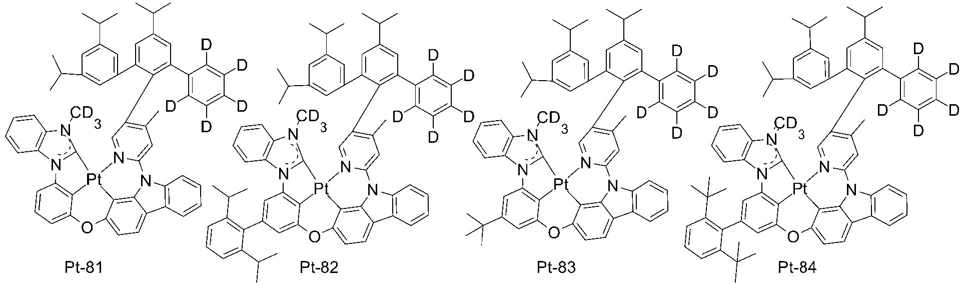

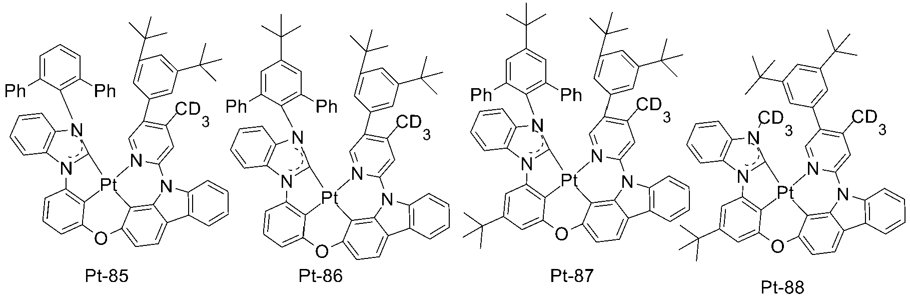

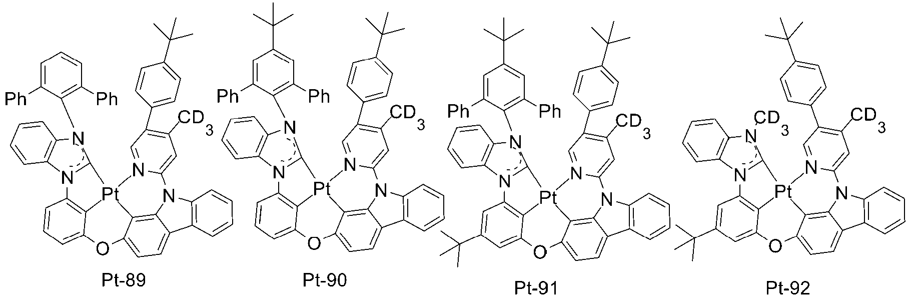

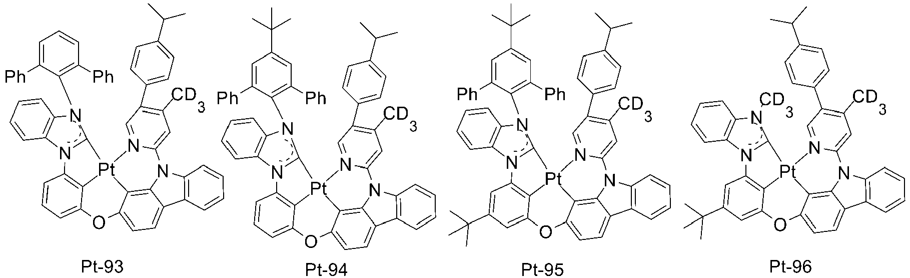

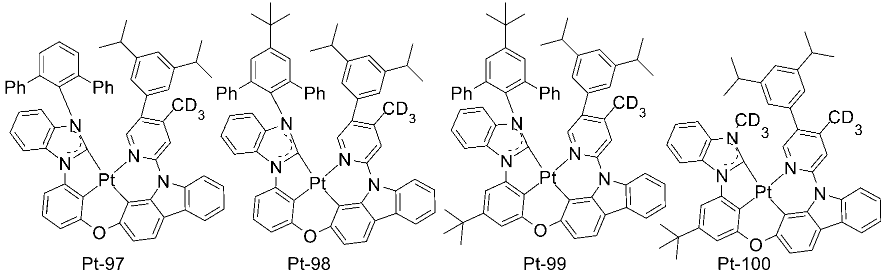

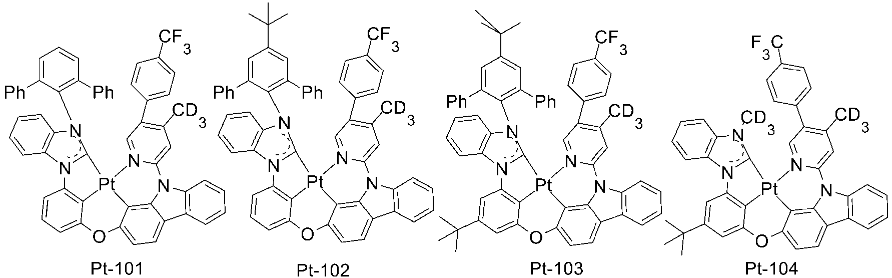

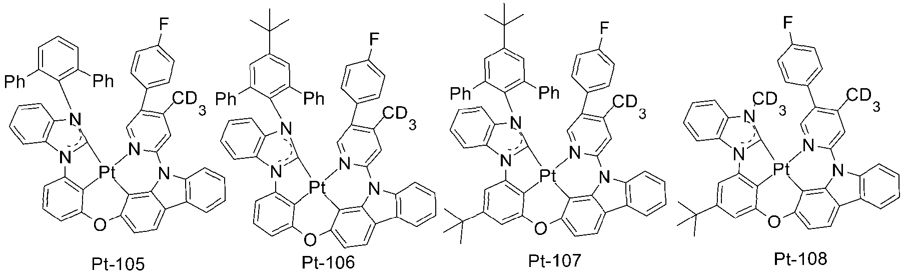

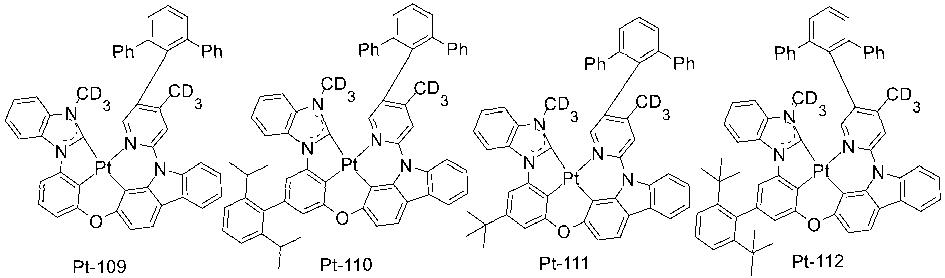

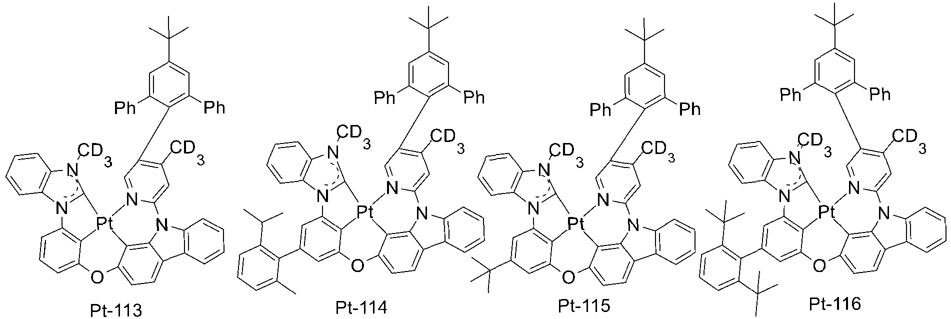

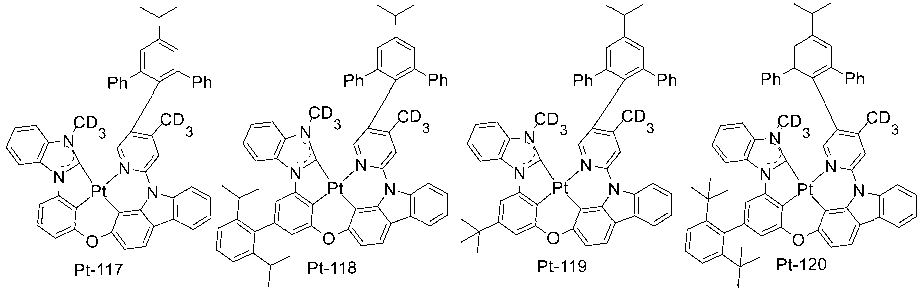

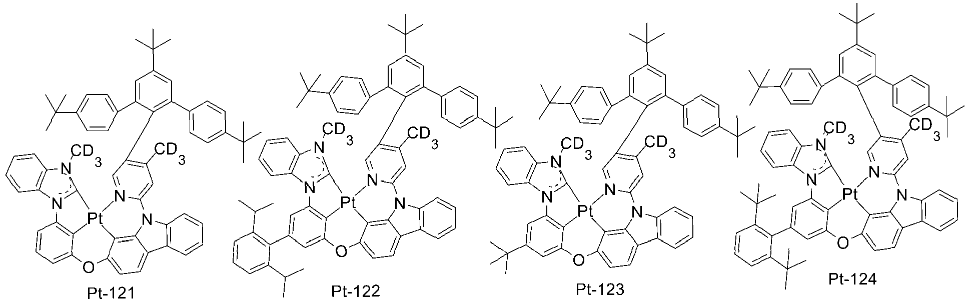

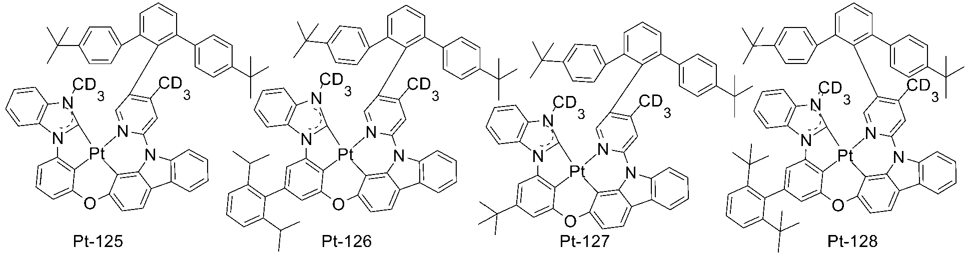

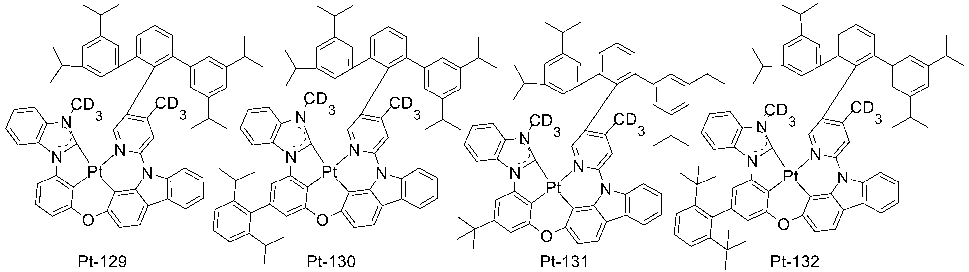

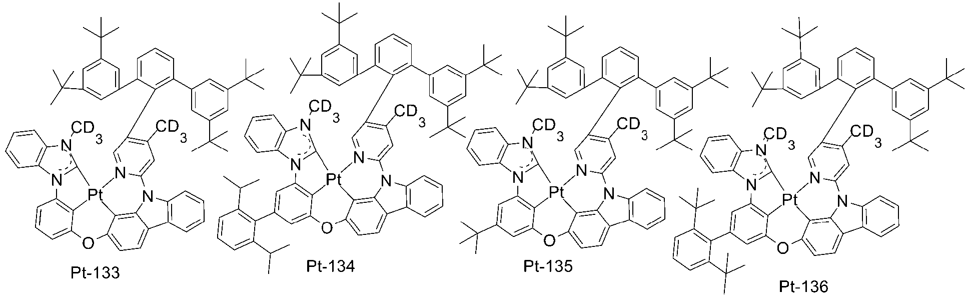

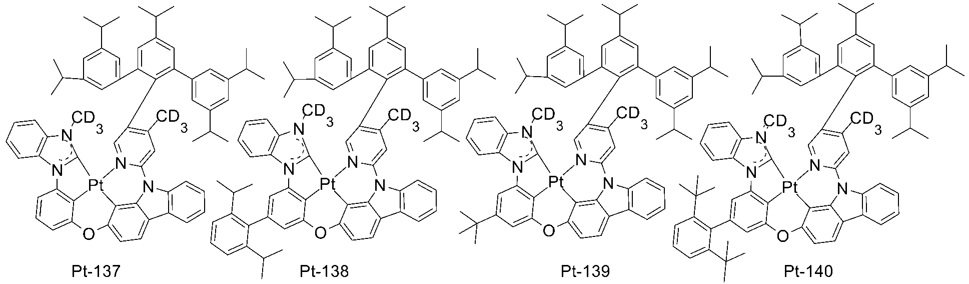

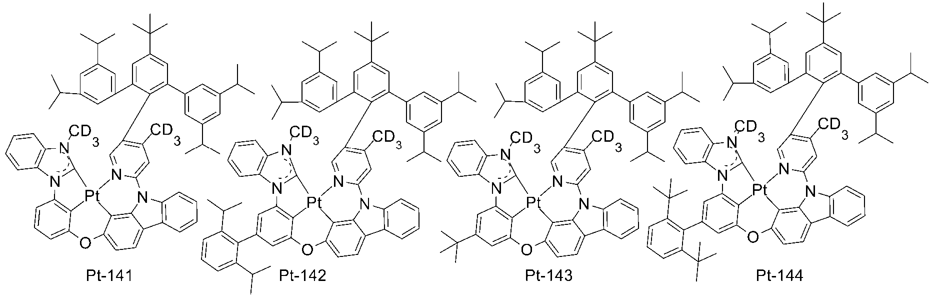

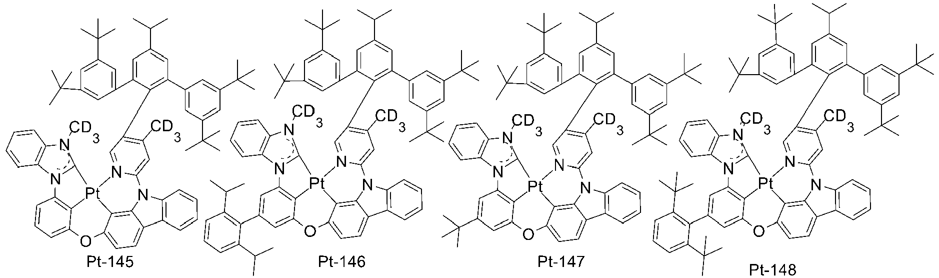

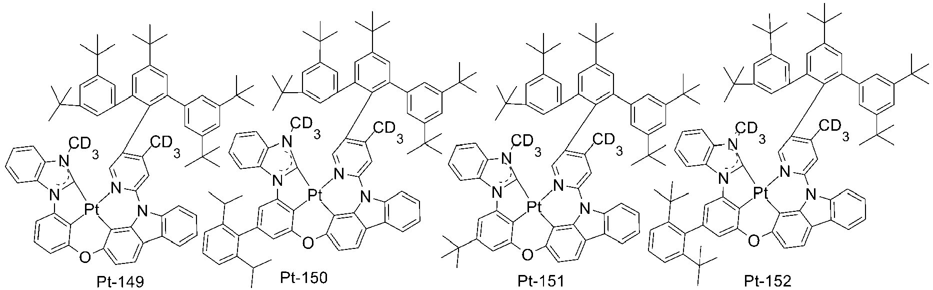

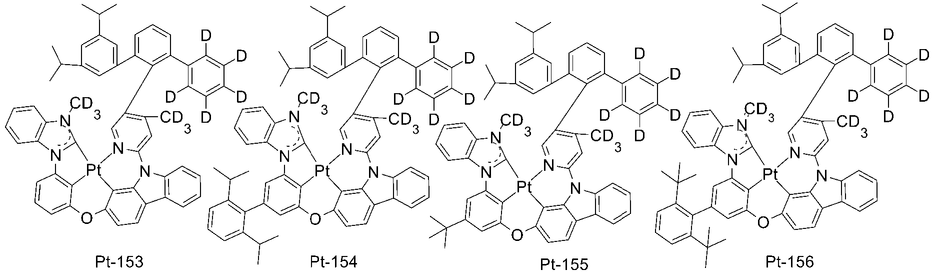

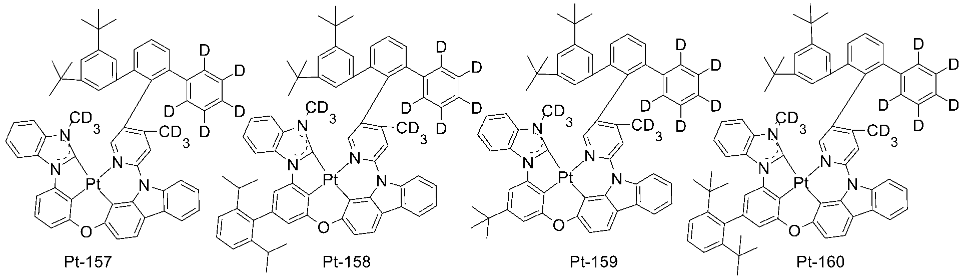

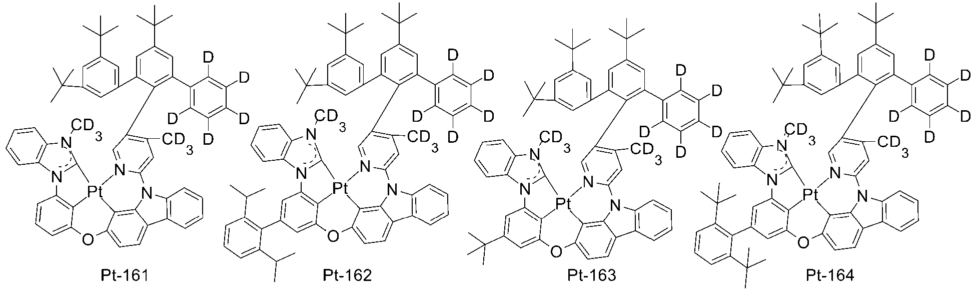

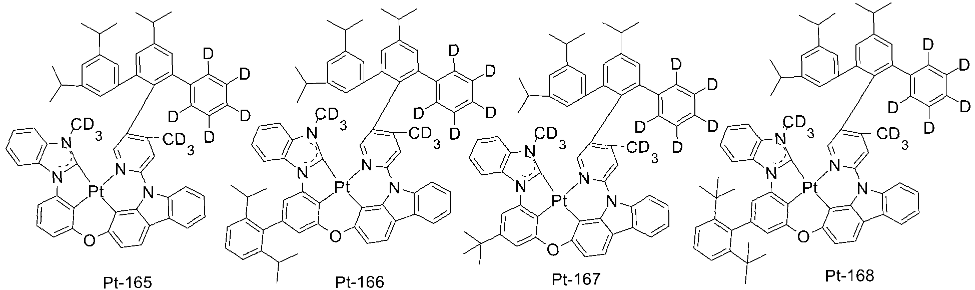

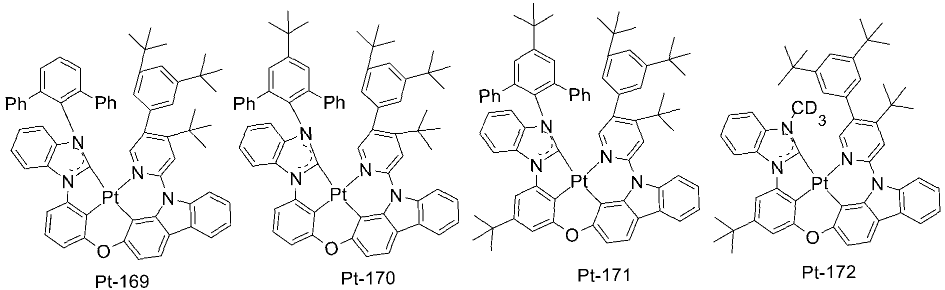

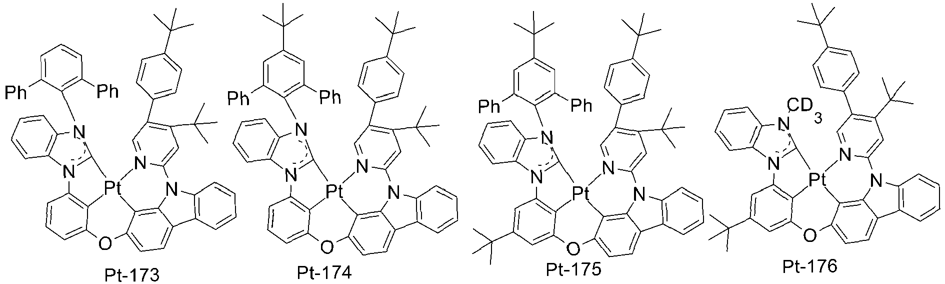

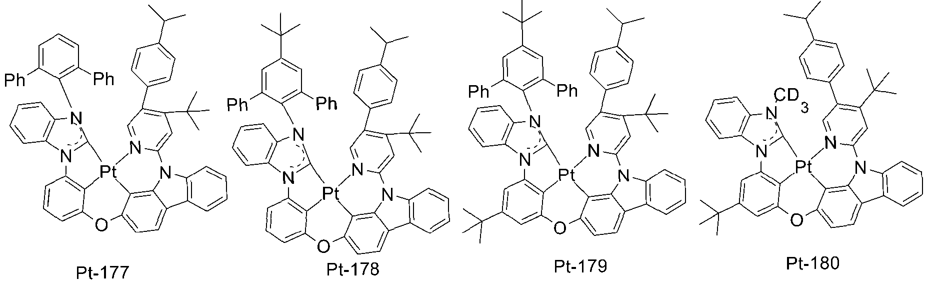

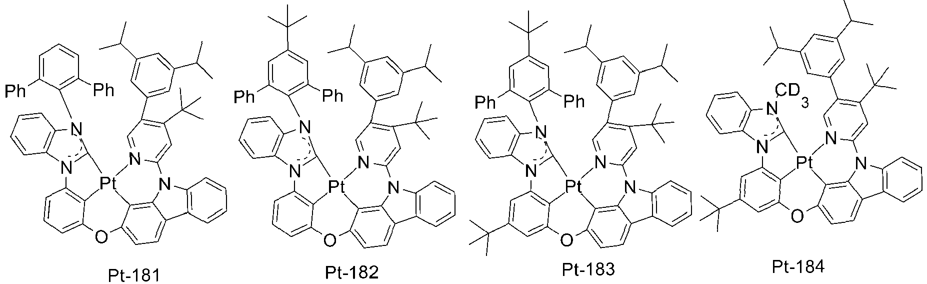

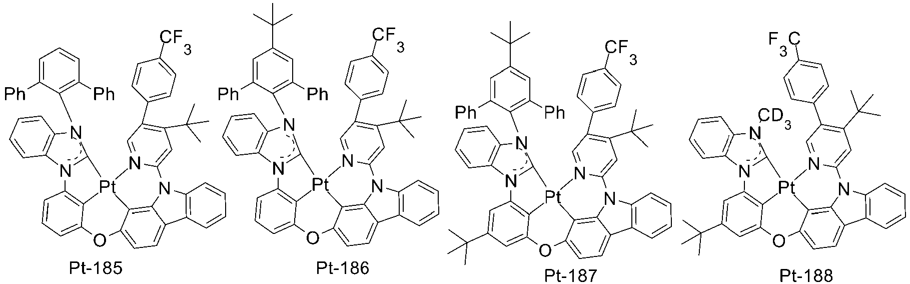

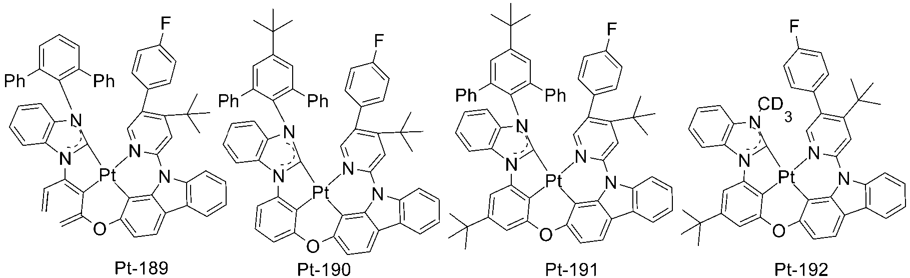

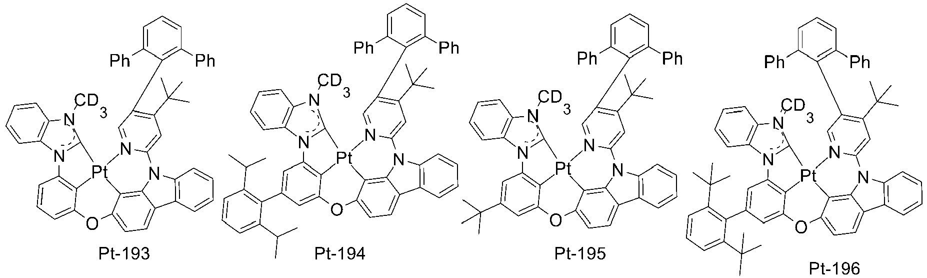

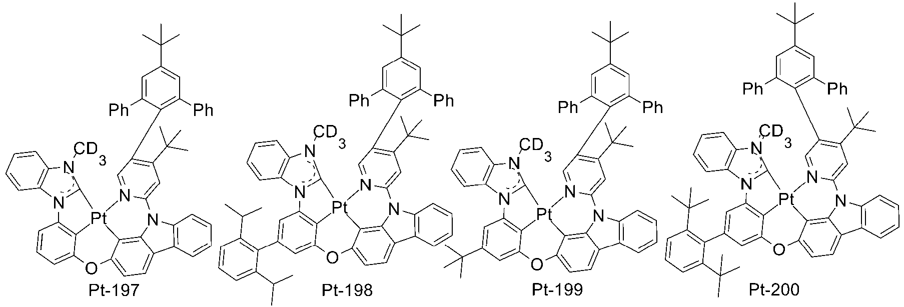

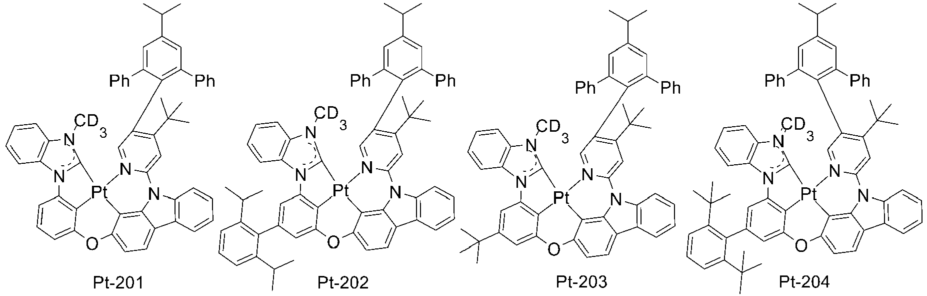

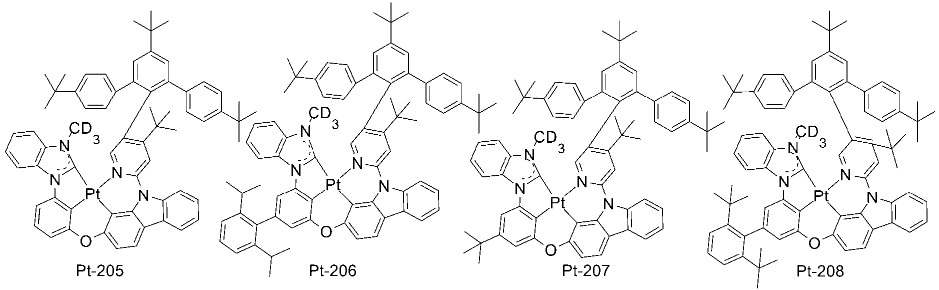

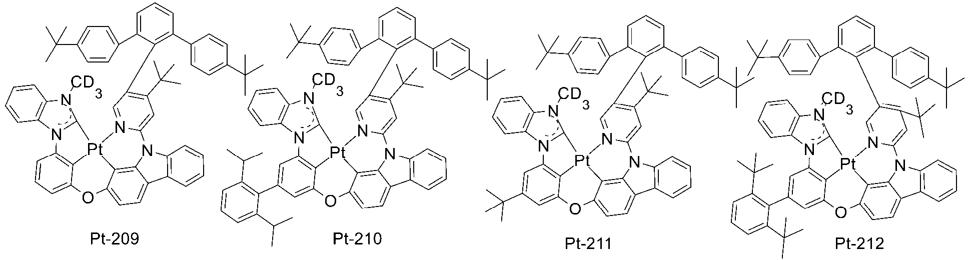

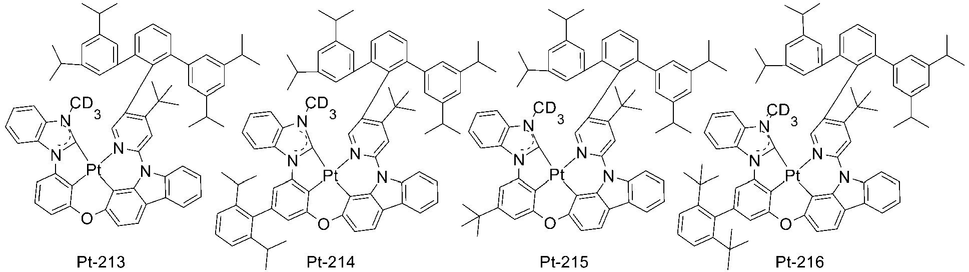

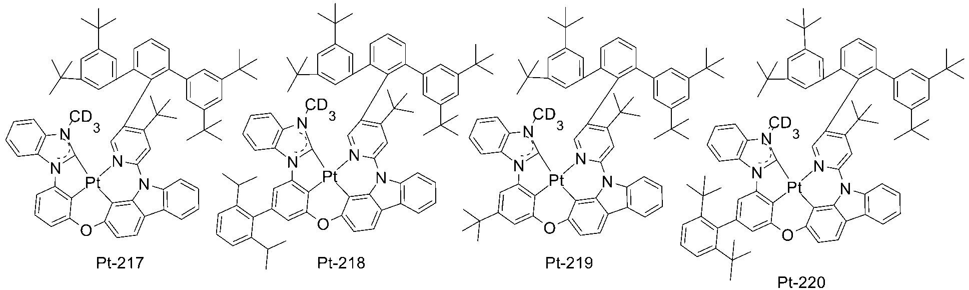

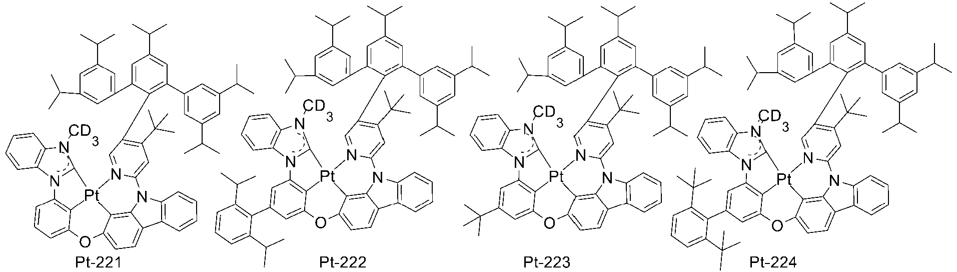

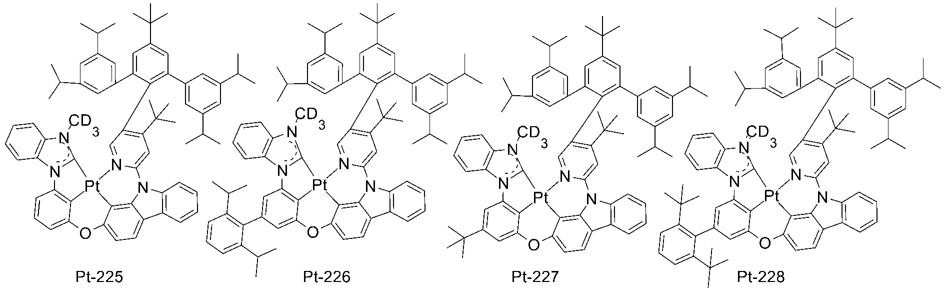

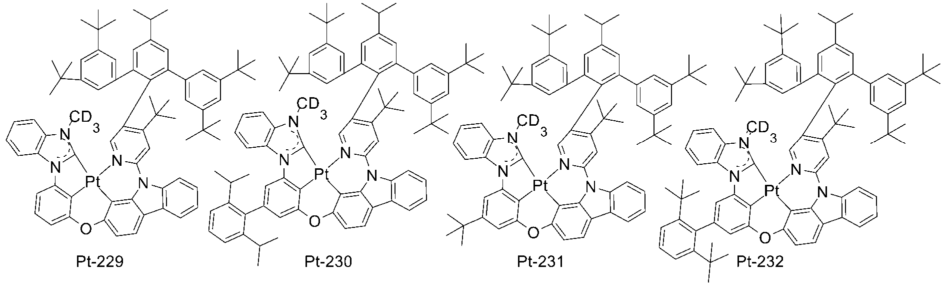

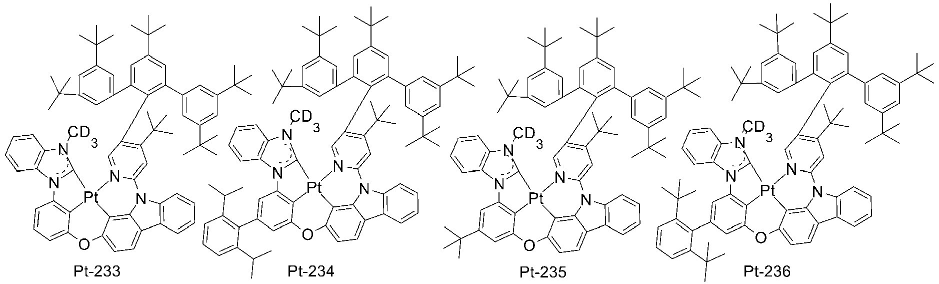

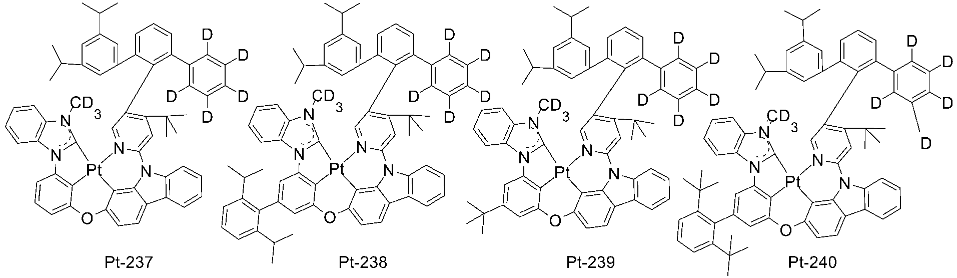

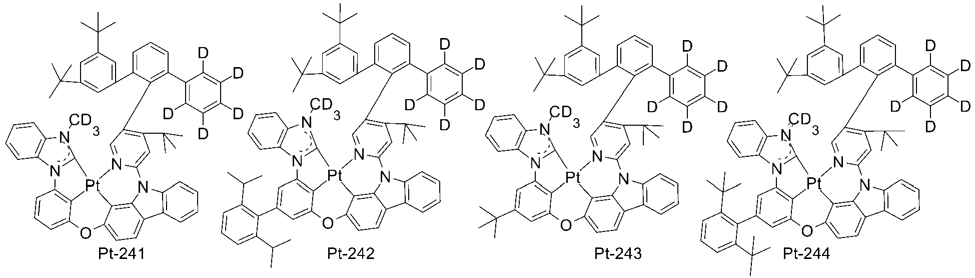

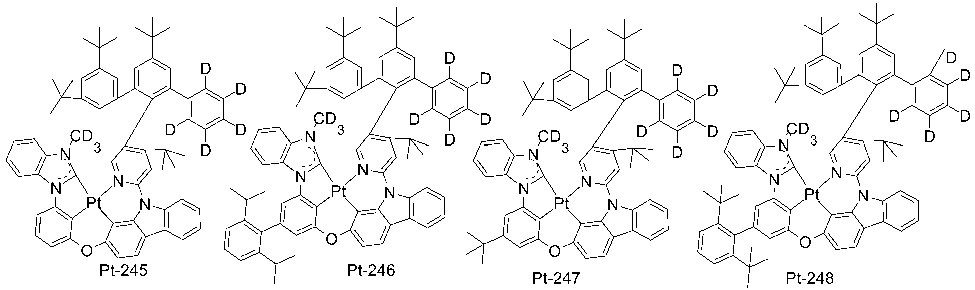

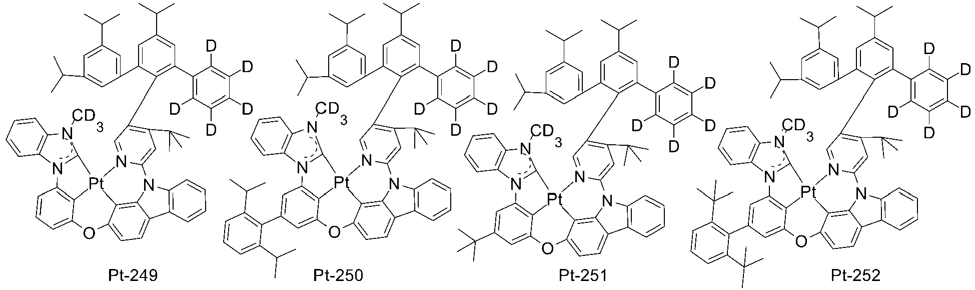

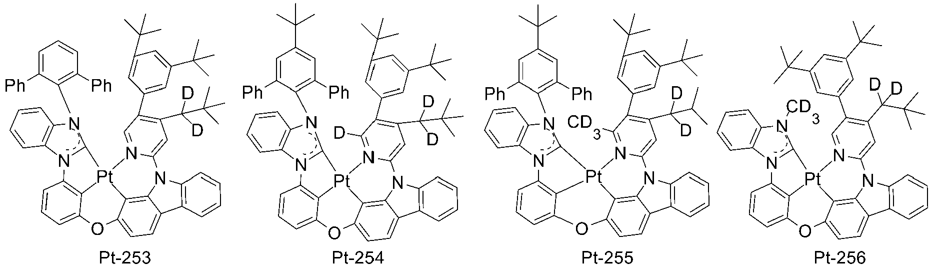

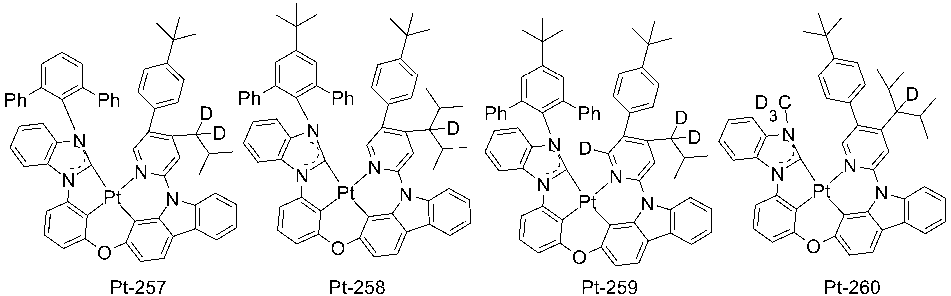

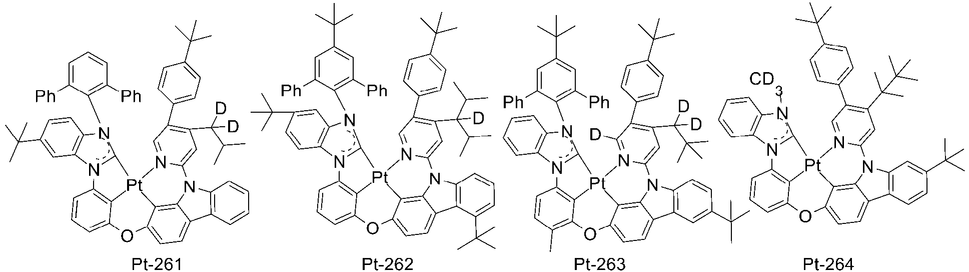

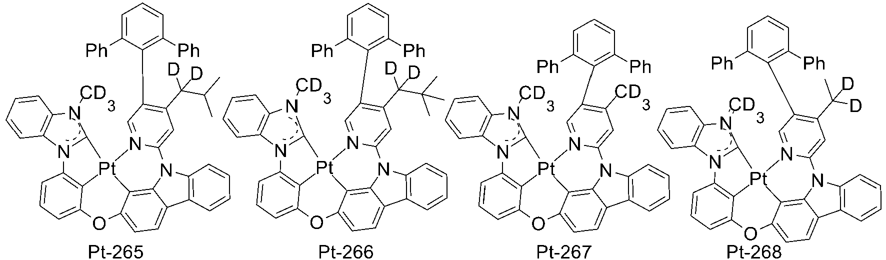

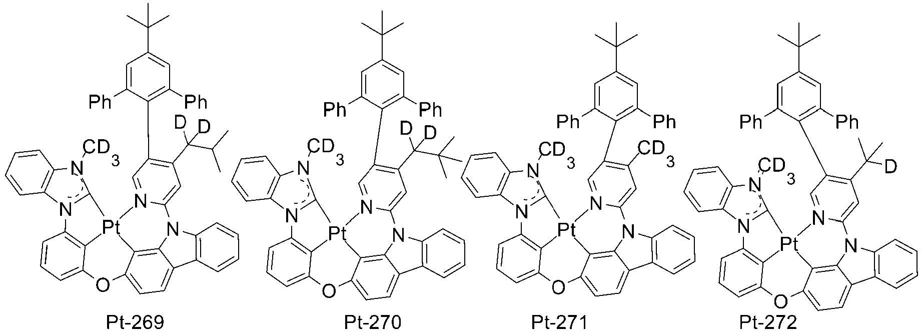

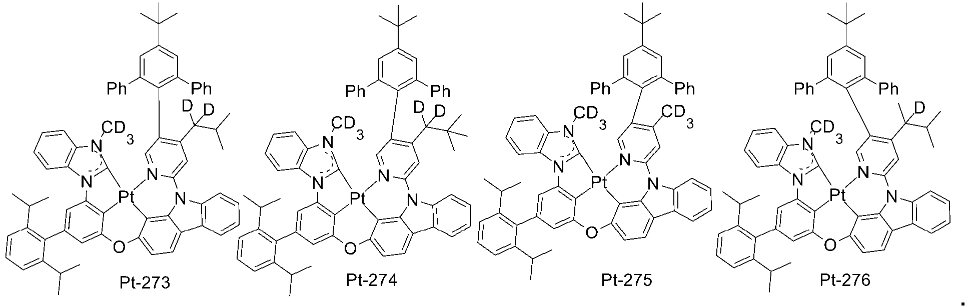

Furthermore, the present disclosure further provides an application of the tetradentate cyclometalated platinum (II) complex having the structure as shown in formula (I) in an electronic device.

Furthermore, the electronic device includes an organic electroluminescent device (OLED), an organic integrated circuit (O-IC), an organic field-effect transistor (O-FET), an organic thin-film transistor (O-TFT), an organic light-emitting transistor (O-LET), an organic solar cell (O-SC), an organic optical detector, an organophotoreceptor, an organic field-quench device (O-FQD), a light-emitting electrochemical cell (LEC) and an organic laser diode (O-laser).

In another aspect, the present disclosure further provides an organic electroluminescent device. The organic electroluminescent device includes the tetradentate cyclometalated platinum (II) complex having the structure as shown in formula (I).

Furthermore, the organic electroluminescent device includes a cathode, an anode and an organic functional layer between the cathode and the anode. The organic functional layer contains the tetradentate cyclometalated platinum (II) complex having the structure as shown in formula (I).

Preferably, the organic functional layer includes a light-emitting layer. The light-emitting layer contains the tetradentate cyclometalated platinum (II) complex having the structure as shown in formula (I).

Furthermore, the light-emitting layer further includes a fluorescent dopant material. The fluorescent dopant material is a boron-containing organic molecular light-emitting material.

In still another aspect, the present disclosure further provides an organic optoelectronic device. The organic optoelectronic device includes: a substrate layer, a first electrode disposed on the substrate; an organic light-emitting functional layer disposed on the first electrode, and a second electrode disposed on the organic light-emitting functional layer. The organic light-emitting functional layer contains the tetradentate cyclometalated platinum (II) complex having the structure as shown in formula (I). For example, the platinum(II) complex may be contained as a light-emitting material in the organic light-emitting functional layer.

Furthermore, the organic light-emitting functional layer further includes any one or more fluorescent dopant materials.

The present disclosure further provides a composition. The composition contains the tetradentate cyclometalated platinum (II) complex having the structure as shown in formula (I). Preferably, the composition further contains a fluorescent dopant material. The fluorescent dopant material is preferably a boron-containing compound that is sensitizable to phosphorescence.

The present disclosure further provides a formulation. The formulation contains the tetradentate cyclometalated platinum (II) complex having the structure as shown in formula (I) and at least one solvent, or contains the composition described above and at least one solvent.

The solvent is not particularly limited, and may be used, for example, an unsaturated hydrocarbon solvent such as toluene, xylene, mesitylene, tetralin, decahydronaphthalene, dicyclohexane, n-butylbenzene, sec-butylbenzene or tert-butylbenzene, or a halogenated saturated hydrocarbon solvent such as carbon tetrachloride, chloroform, dichloromethane, dichloroethane, chlorobutane, bromobutane, chloropentane, bromopentane, chlorohexane, bromohexane, chlorocyclohexane or bromocyclohexane, or a halogenated unsaturated hydrocarbon solvent such as chlorobenzene, dichlorobenzene or trichlorobenzene, or an ether solvent such as tetrahydrofuran or tetrahydropyran, or an ester solvent such as alkyl benzoate, as well known to those skilled in the art.

The present disclosure further provides a display or lighting apparatus. The apparatus includes at least one organic optoelectronic device each as described above.

**Compared with the prior art, the beneficial effects of the present disclosure are as follows:**
The present disclosure improves charge distribution of an excited state of the tetradentate cyclometalated platinum(II) complex based on pyridyl-carbazole by introducing a substituent at an appropriate position of a ligand of the compound, endowing an excited state of the tetradentate cyclometalated platinum(II) complex material with a greater proportion of metal-to-pyridine-fused carbene charge transfer (³MLCT) states. This facilitates an increase in radiative rate, thereby enhancing lifetime of a device. Provided materials all exhibit excellent chemical and thermal stability, facilitating the fabrication of vacuum-evaporated OLED devices. Organic electroluminescent devices fabricated with compounds of the present disclosure as light-emitting layers demonstrate significant improvements in both current efficiency and lifetime, while also markedly reducing a turn-on voltage. Combining the compounds of the present disclosure with fluorescent dopant materials (boron-containing compounds) may balance transport of holes and electrons, enable more efficient energy transfer between a host and a guest, and enhance light color purity of devices.

### BRIEF DESCRIPTION OF DRAWINGS

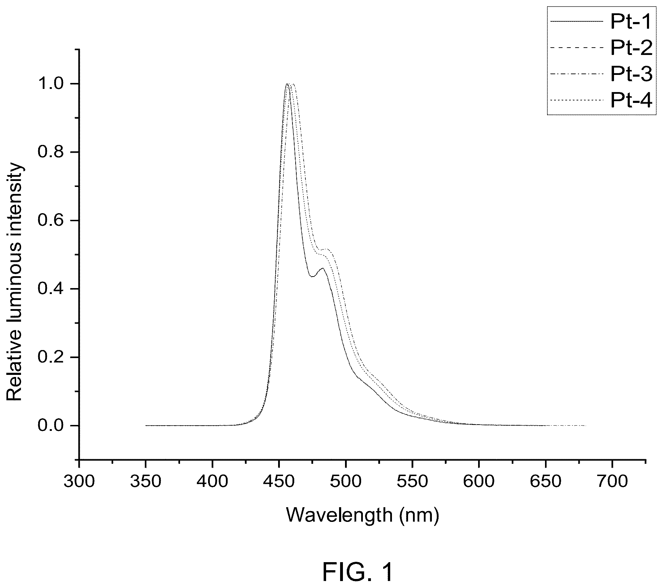

FIG.1 shows emission spectra of compounds **Pt-1** to **Pt-4** in dichloromethane solution at room temperature.

### DETAILED DESCRIPTION

The content of the present disclosure is to be described in detail below. The description of constituent elements below is sometimes formed based on representative embodiments or specific examples of the present disclosure, but the disclosure is not limited to such embodiments or examples.

The term "substituted" as used herein is intended to encompass all allowable substituents for organic compounds. In a broad sense, the allowable substituents include acyclic and cyclic, branched and unbranched, carbocyclic and heterocyclic, and aromatic and non-aromatic substituents for organic compounds. Illustrative substituents include, for example, those described below. The allowable substituents for a suitable organic compound may include one or more substituents, which may be identical or different. For the purposes of the present disclosure, the present disclosure is not intended to limit, in any manner, allowable substituents for organic compounds. Similarly, the terms "substitution" or "substituted with" carry the implicit condition that such substitution conforms to allowable valence bonds of an atom being substituted and a substituent, and that the substitution results in a stable compound (i.e., a compound that does not spontaneously undergo transformation, such as through rearrangement, cyclization or elimination). It is also anticipated that, in certain aspects, unless explicitly indicated to the contrary, an individual substituent may be further optionally substituted (i.e., the individual substituent may be further substituted or unsubstituted).

In defining various terms, "R¹"-"R⁴" are used as general symbols in the present disclosure to denote various specific substituents. The symbols may be any substituents, not limited to those disclosed in the present disclosure; and when defined as certain substituents in one case, the symbols may also be defined as other substituents in other cases. "R¹", "R²" ... "Rⁿ" (where n is an integer) used in the present disclosure may independently possess one or more of the groups listed above. For example, if R¹ is a linear alkyl group, a hydrogen atom of the alkyl group may optionally be substituted with a hydroxyl group, an alkoxy group, an alkyl group, halogen, etc. Depending on selected groups, a first group may be incorporated within a second group; alternatively, a first group may be suspended from, i.e., connected to, a second group.

The terms "alkyl" and "alkyl group" as used in the present disclosure each refer to a branched or unbranched saturated hydrocarbyl group having 1 to 60 carbon atoms, such as methyl, ethyl, n-propyl, isopropyl, n-butyl, isobutyl, sec-butyl, tert-butyl, n-pentyl, isopentyl, sec-pentyl, neopentyl, hexyl, heptyl, octyl, nonyl, decyl, dodecyl, tetradecyl, hexadecyl, octadecyl, eicosyl and tetracosyl. The alkyl group may be cyclic or non-cyclic. The alkyl group may be branched or unbranched. The alkyl group may also be substituted or unsubstituted. For example, the alkyl group may be substituted with one or more substituents, and includes but not limited to optionally substituted alkyl, cycloalkyl, alkoxy, amino, halogen, hydroxyl, nitro, silyl, sulfur-oxo (sulfo-oxo), or mercapto groups as described in the present disclosure.

The term "aryl" and "aryl group" as used herein each refer to a group containing any carbon-based aromatic group containing 5 to 60 carbon atoms. The carbon-based aromatic group includes, but is not limited to, phenyl, naphthyl, phenyl, biphenyl, phenoxyphenyl, anthryl, phenanthryl, etc. The terms "aryl" and "aryl group" each also include "heteroaryl" or "heteroaryl group", and are each defined as a group containing an aromatic group, the aromatic group possessing at least one heteroatom introduced into a ring of the aromatic group. Examples of a heteroatom include but are not limited to a nitrogen atom, an oxygen atom, a sulfur atom and a phosphorus atom. Similarly, the terms "non-heteroaryl" and "non-heteroaryl group" (which are also included in the terms "aryl" and "aryl group") each define groups containing an aromatic group, the aromatic group containing no heteroatoms. The aryl group may be substituted or unsubstituted. The aryl group may be substituted with one or more substituents, a substituent therein including but not limited to alkyl, cycloalkyl, alkoxy, alkenyl, cycloalkenyl, alkynyl, cycloalkynyl, aryl, heteroaryl, aldehyde, amino, carboxyl, ester, halogen, hydroxyl, carbonyl, azido, nitro, silyl, sulfur-oxo (sulfo-oxo) and mercapto listed in the present disclosure.

The compounds in the present disclosure may include an "optionally substituted" moiety. Generally, the term "substituted" (whether or not preceded by the term "optionally") means that one or more hydrogens on an indicated moiety are replaced with suitable substituent(s). Unless otherwise specified, an "optionally substituted" group may have a suitable substituent at each substitutable position of the group; and when more than one position in any given structure may be substituted with more than one substituent selected from specified groups, a substituent at each position may be identical or different. Substituent combinations envisaged in the present disclosure are preferably those that form stable or chemically viable compounds. In certain aspects, unless explicitly indicated to the contrary, it is also contemplated that each substituent may be further optionally substituted (i.e., the substituent may be further substituted or unsubstituted).

Compounds disclosed herein can exhibit desired properties and possess emission spectra and/or absorption spectra that can be modulated by selecting suitable ligands. In another aspect, the present disclosure may exclude any one or more of the compounds, structures, or parts thereof specifically described herein.

The compounds of the present disclosure may be prepared by various methods, including but not limited to those described in embodiments provided herein.

It will be noted that both the general description above and the detailed description below are merely illustrative and explanatory, but are not intended to be limiting. The present disclosure may be more readily understood by reference to specific embodiments and examples included therein.

Before disclosing and describing the compounds of the present disclosure, devices and/or methods of the present disclosure, it will be understood that they are not limited to specific synthesis methods (unless otherwise indicated) or specific reagents (unless otherwise indicated), as these are readily variable. It will also be understood that the terms used herein are intended solely for the purpose of describing specific aspects, but are not intended to be limiting. Any methods and materials similar or equivalent to those described herein may be used in the practice or testing, and exemplary methods and materials are to be described below. All raw materials and solvents used in synthetic examples are commercially available unless otherwise specified. The solvents are used as received without further processing.

A substrate described herein may be any substrate used in typical organic optoelectronic devices. The substrate may be a glass substrate or a transparent plastic substrate, or may be a substrate of an opaque material such as silicon or stainless steel, or may be a flexible polyimide (PI) film. Different substrates are different in mechanical strength, thermal stability, transparency, surface smoothness and waterproofness; and depending on natures of the different substrates, the different substrates are used in different directions. Materials for a hole injection layer, a hole transport layer and an electron injection layer may be selected from any known relevant materials used in OLED apparatuses, which is not specially limited herein.

### Synthesis Embodiments

Examples of compound synthesis, composition, devices or methods below are provided solely to illustrate general approaches within the field, but are not intended to limit the scope of protection of the present disclosure. While every effort has been made to ensure the accuracy of data (quantities, temperatures, etc.) presented herein, some discrepancies may exist. Unless otherwise specified, all weights are measured separately, temperatures are in degrees Celsius (°C) or at room temperature (RT), and pressures are near atmospheric pressure.

The examples below provide methods for preparing new compounds, but the preparation of such compounds is not limited thereto. In the specialized technical field, since the compounds disclosed in the present disclosure are readily modified and prepared, synthesis of the compounds may be achieved by using the methods listed below or other methods. The following examples are provided merely as illustrations, but are not intended to limit the scope of protection of the present disclosure. Temperatures, catalysts, concentrations, reactants and reaction processes may all be modified, so as to select different conditions for preparing the compounds from various reactants.

¹H NMR (500 MHz) spectra are measured on an ANANCE III (500M) nuclear magnetic resonance spectrometer. Unless otherwise specified, the NMR spectra are all recorded by using dimethyl sulfoxide-*d₆* (DMSO-*d₆*) or CDCl₃ containing 0.1% (w/w) tetramethylsilane (TMS) as a solvent. For ¹H NMR spectra recorded by using CDCl₃ as a solvent, TMS (δ=0.00 ppm) serves as an internal standard; and for ¹H NMR spectra recorded by using DMSO-*d₆* as a solvent, TMS (δ=0.00 ppm), a residual DMSO peak (δ=2.50 ppm) or a residual water peak (δ=3.33 ppm) serves as an internal standard. In ¹³C NMR spectra, CDCl₃ (δ=77.00 ppm) or DMSO-*d₆* (δ=39.52 ppm) serves as an internal standard. High performance liquid chromatography-mass spectrometry (HPLC-MS) spectra are measured on an Agilent 6210 TOF LC/MS mass spectrometer. High-resolution mass spectrometry (HRMS) spectra are measured on an Agilent 6210 TOF LC/MS liquid chromatography time-of-flight mass spectrometer. In data of the ¹H NMR spectra, s=singlet, d=doublet, t=triplet, q=quartet, p=quintet, m=multiplet, br=broad.

### Synthesis of Intermediate A-1-OH

The synthetic route of intermediate **A-1-OH** is as follows: 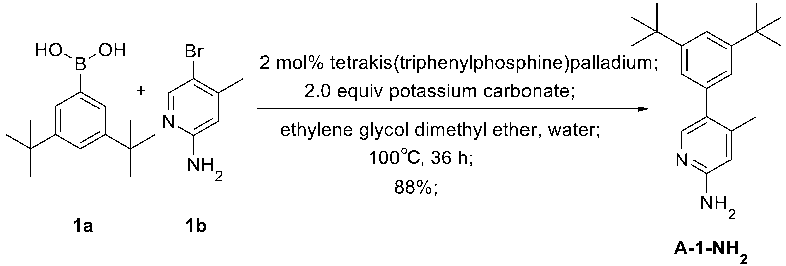 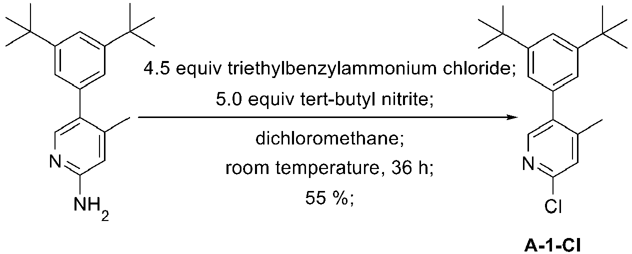 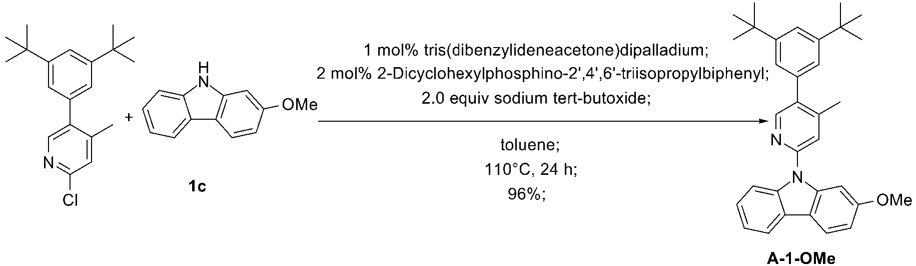 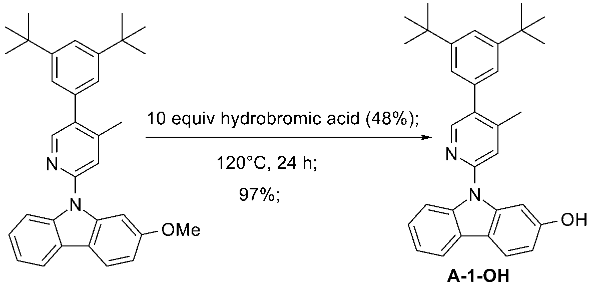
(1) Compound **1a** (1 g, 4.27 mmol, 1.2 equivalents), compound **1b** (666 mg, 3.56 mmol, 1.0 equivalent), tetrakis(triphenylphosphine)palladium (82 mg, 0.07 mmol, 2 mol %) and potassium carbonate (984 mg, 7.12 mmol, 2.0 equivalents) are added into a three-neck flask equipped with a magnetic stir bar; then, the flask is purged with nitrogen three times, and ethylene glycol dimethyl ether (6 mL) and water (6 mL) are added therein under a nitrogen atmosphere; the mixture is heated to 100°C for reaction for 36 hours and then cooled to room temperature; then, a solvent therein is removed by distillation under reduced pressure, so as to obtain a crude product; and the crude product is purified by silica gel column chromatography (an eluent used therein being a mixture of dichloromethane and ethyl acetate (EA), and a volume ratio of the dichloromethane and the EA being 10:1) to afford 994 mg of a yellow solid (recorded as compound **A-1-NH₂)** in 88% yield.
(2) Compound **A-1-NH₂** (994 mg, 3.35 mmol, 1.0 equivalent) and triethylbenzylammonium chloride (4.38 g, 19.22 mmol, 4.5 equivalents) are added into a three-neck flask equipped with a magnetic stir bar; then, the flask is purged with nitrogen three times, and tert-butyl nitrite (2.2 g, 21.35 mmol, 5.0 equivalents) and dichloromethane (10 mL) are added therein under a nitrogen atmosphere; the mixture is stirred and allowed to react at room temperature in the absence of light for 36 hours; then, a solvent therein is removed by distillation under reduced pressure, so as to obtain a crude product; and the crude product is purified by silica gel column chromatography (an eluent used therein being a mixture of dichloromethane and EA, and a volume ratio of the dichloromethane and the EA being 10:1) to afford 670 mg of a yellow oily substance (recorded as compound **A-1-Cl**) in 55% yield.
(3) Compound **A-1-Cl** (7g, 22.16 mmol, 1.0 equivalent), compound **1c** (6.56 g, 33.24 mmol, 1.5 equivalents), tris(dibenzylideneacetone)dipalladium (201 mg, 0.22 mmol, 1 mol%), 2-Dicyclohexylphosphino-2',4',6'-triisopropylbiphenyl (183 mg, 0.44 mmol, 2 mol%) and sodium tert-butoxide (4.3 g, 44.32 mmol, 2.0 equivalents) are added into a three-neck flask equipped with a magnetic stir bar; then, the flask is purged with nitrogen three times, and toluene (200 mL) is added therein under a nitrogen atmosphere; the mixture is heated to 110°C for reaction for 24 hours and then cooled to room temperature; then, a solvent therein is removed by distillation under reduced pressure, so as to obtain a crude product; and the crude product is purified by silica gel column chromatography (an eluent used therein being a mixture of petroleum ether and EA, and a volume ratio of the petroleum ether and the EA being 20:1) to afford 10.12 g of a gray solid (recorded as compound **A-1-MOe)** in 96% yield.
(4) Compound **A-1-MOe** (10.12 g, 21.23 mmol, 1.0 equivalent) and hydrobromic acid (48% by weight) (50 mL, 212.3 mmol, 10 equivalents) are added into a single-necked flask equipped with a magnetic stir bar; the mixture is heated to 120°C for reaction for 24 hours and then cooled to room temperature; pH of the reacted mixture is adjusted to 7 to 8 with a saturated sodium bicarbonate solution, and then the mixture is extracted three times with dichloromethane to collect respective organic layers, and the organic layers are combined to obtain an organic phase; distillation under reduced pressure is performed on the organic phase to remove a solvent therein, so as to obtain a crude product; and the crude product is triturated with EA and petroleum ether to afford 9.5 g of a white solid (recorded as intermediate **A-1-OH)** in 97% yield.

### Synthesis of Intermediate B-1-OH

The synthetic route of intermediate **B-1-OH** is as follows: 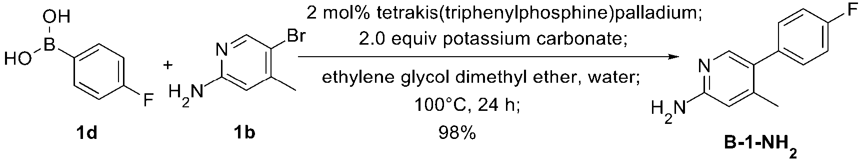 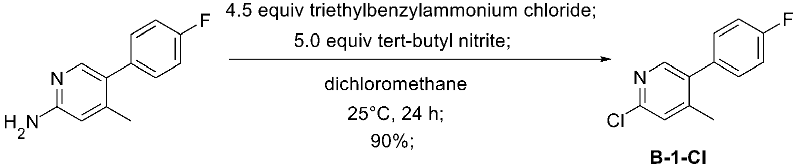 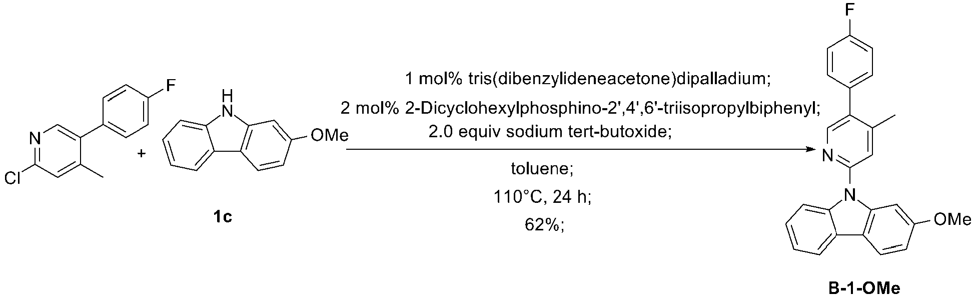 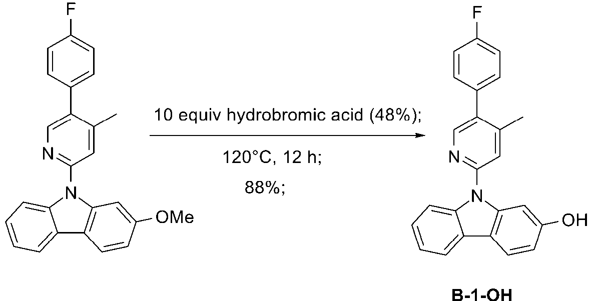
(1) Compound **1d** (4 g, 28.56 mmol, 1.2 equivalents), compound **1b** (4.45 g, 23.8 mmol, 1.0 equivalent), tetrakis(triphenylphosphine)palladium (496 mg, 0.44 mmol, 2 mol%) and potassium carbonate (6.58 g, 47.6 mmol, 2.0 equivalents) are added into a three-neck flask equipped with a magnetic stir bar; then, the flask is purged with nitrogen three times, and ethylene glycol dimethyl ether (16 mL) and water (16 mL) are added therein under a nitrogen atmosphere; the mixture is heated to 100°C for reaction for 36 hours and then cooled to room temperature; then, a solvent therein is removed by distillation under reduced pressure, so as to obtain a crude product; and the crude product is purified by silica gel column chromatography (an eluent used therein being a mixture of dichloromethane and EA, and a volume ratio of the dichloromethane and the EA being 10:1) to afford 4.71 g of a yellow solid (recorded as compound **B-1-NH₂**) in 98% yield.
(2) Compound **B-1-NH₂** (4.82 g, 23.82 mmol, 1.0 equivalent) and triethylbenzylammonium chloride (24.43 g, 107.11 mmol, 4.5 equivalents) are added into a three-neck flask equipped with a magnetic stir bar; then, the flask is purged with nitrogen three times, and tert-butyl nitrite (12.27 g, 199 mmol, 5.0 equivalents) and dichloromethane (80 mL) are added therein under a nitrogen atmosphere; the mixture is stirred and allowed to react at room temperature in the absence of light for 36 hours; then, a solvent therein is removed by distillation under reduced pressure, so as to obtain a crude product; and the crude product is purified by silica gel column chromatography (an eluent used therein being a mixture of dichloromethane and EA, and a volume ratio of the dichloromethane and the EA being 10:1) to afford 4.74 g of a red oily substance (recorded as compound **B-1-Cl**) in 90% yield.
(3) Compound **B-1-Cl** (3g, 14 mmol, 1.0 equivalent), compound **1c** (4.14 g, 21 mmol, 1.5 equivalents), tris(dibenzylideneacetone)dipalladium (128 mg, 0.14 mmol, 1 mol%), 2-Dicyclohexylphosphino-2',4',6'-triisopropylbiphenyl (166 mg, 0.28 mmol, 2 mol%) and sodium tert-butoxide (2.69 g, 28 mmol, 2.0 equivalents) are added into a three-neck flask equipped with a magnetic stir bar; then, the flask is purged with nitrogen three times, and toluene (60 mL) is added therein under a nitrogen atmosphere; the mixture is heated to 110°C for reaction for 24 hours and then cooled to room temperature; then, a solvent therein is removed by distillation under reduced pressure, so as to obtain a crude product; and the crude product is purified by silica gel column chromatography (an eluent used therein being a mixture of petroleum ether and EA, and a volume ratio of the petroleum ether and the EA being 20:1) to afford 3.3 g of a gray solid in 62% yield.

### Synthesis of Intermediate A-2-Cl

**The synthetic route of intermediate A-2-Cl is as follows:**

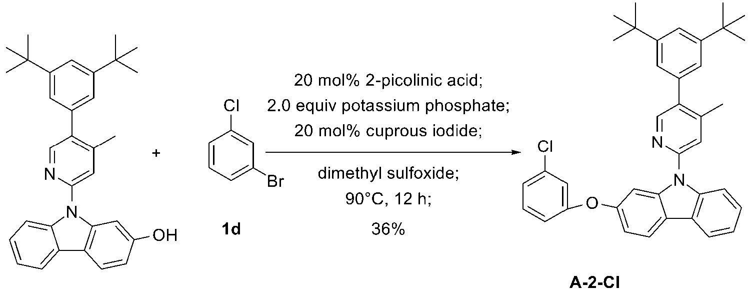

Potassium phosphate (9.2 g, 4.32 mmol, 2.0 equivalents) is added into a three-necked flask equipped with a magnetic stir bar, and moisture therein is removed by means of a hot air gun under a vacuum atmosphere; then, intermediate **A-1-OH** (1 g, 2.16 mmol, 1.0 equivalent), 2-picolinic acid (53 mg, 0.43 mmol, 20 mol%) and cuprous iodide (82 mg, 0.43 mmol, 20 mol%) are added therein; then, the flask is purged with nitrogen three times, and compound **1d** (830 mg, 4.32 mmol, 2.0 equivalents) and dimethyl sulfoxide (20 mL) are added therein under a nitrogen atmosphere; the mixture is heated to 90°C for reaction for 36 hours and then cooled to room temperature; then, the reaction is quenched with deionized water; the reacted mixture is extracted three times with EA to collect respective organic layers, and the organic layers are combined to obtain an organic phase; distillation under reduced pressure is performed on the organic phase to remove a solvent therein, so as to obtain a crude product; and the crude product is purified by silica gel column chromatography (an eluent used therein being a mixture of EA and petroleum ether, and a volume ratio of the EA and the petroleum ether being 40:1) to afford 450 mg of a yellow oily substance in 36% yield.

### Synthesis of Intermediate A-3-Cl

The synthetic route of intermediate **A-3-Cl** is as follows: 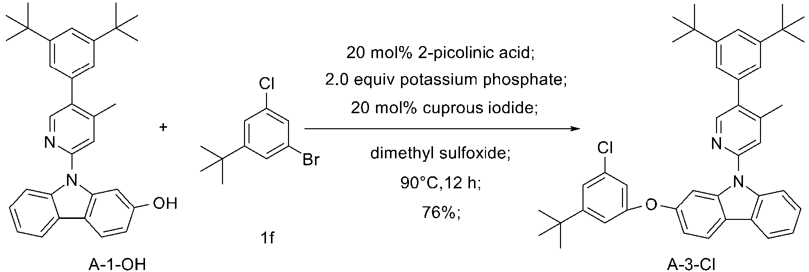
(1) Potassium phosphate (8.8 g, 20.72 mmol, 2.0 equivalents) is added into a three-necked flask equipped with a magnetic stir bar, and moisture therein is removed by means of a hot air gun under a vacuum atmosphere; then, intermediate **A-1-OH** (9.59 g, 20.72 mmol, 1.0 equivalent), 2-picolinic acid (510 mg, 4.14 mmol, 20 mol%) and cuprous iodide (788 mg, 4.14 mmol, 20 mol%) are added therein; then, the flask is purged with nitrogen three times, and compound **1f** (11.38 g, 41.44 mmol, 2.0 equivalents) and dimethyl sulfoxide (100 mL) are added therein under a nitrogen atmosphere; the mixture is heated to 90°C for reaction for 12 hours and then cooled to room temperature; then, the reaction is quenched with deionized water; the reacted mixture is extracted three times with EA to collect respective organic layers, and the organic layers are combined to obtain an organic phase; distillation under reduced pressure is performed on the organic phase to remove a solvent therein, so as to obtain a crude product; and the crude product is purified by silica gel column chromatography (an eluent used therein being a mixture of EA and petroleum ether, and a volume ratio of the EA and the petroleum ether being 50:1) to afford 9.89 g of a yellow oily substance (recorded as **A-3-Cl**) in 76% yield. A ¹H NMR characterization result for the yellow oily substance is as follows: ¹H NMR (500 MHz, Chloroform-d) δ 8.54 (s, 1H), 8.09 (dd, *J*=10, 5 Hz, 2H), 7.84 (d, *J=10* Hz, 1H), 7.58 (d, *J*=5 Hz, 1H), 7.52-7.48 (m, 2H), 7.47-7.42 (m, 1H), 7.35-7.30 (m, 1H). 7.25 (d, *J=10* Hz, 2H), 7.06 (t, *J*=5 Hz, 1H), 7.04-6.99 (m, 2H), 6.78 (t, *J*=5 Hz, 1H), 2.42 (s, 3H), 1.39 (s, 18H), 1.28 (s, 9H).

### Synthesis of Intermediate A-4-Cl

The synthetic route of intermediate **A-4-Cl** is as follows: 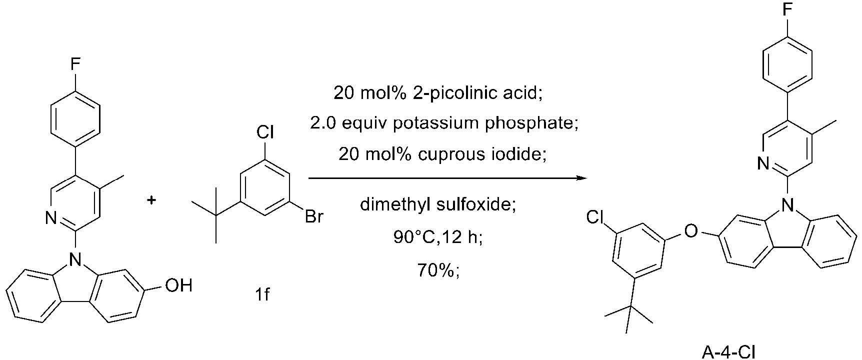
(1) Potassium phosphate (1.27 g, 6 mmol, 2.0 equivalents) is added into a three-necked flask equipped with a magnetic stir bar, and moisture therein is removed by means of a hot air gun under a vacuum atmosphere; then, intermediate **B-1-OH** (1 g, 3 mmol, 1.0 equivalent), 2-picolinic acid (37 mg, 0.3 mmol, 20 mol%) and cuprous iodide (57 mg, 0.3 mmol, 10 mol%) are added therein; then, the flask is purged with nitrogen three times, and compound 1f (1.49 g, 6 mmol, 2.0 equivalents) and dimethyl sulfoxide (20 mL) are added therein under a nitrogen atmosphere; the mixture is heated to 90°C for reaction for 12 hours and then cooled to room temperature; then, the reaction is quenched with deionized water; the reacted mixture is extracted three times with EA to collect respective organic layers, and the organic layers are combined to obtain an organic phase; distillation under reduced pressure is performed on the organic phase to remove a solvent therein, so as to obtain a crude product; and the crude product is purified by silica gel column chromatography (an eluent used therein being a mixture of EA and petroleum ether, and a volume ratio of the EA and the petroleum ether being 20:1) to afford 1.13 g of a yellow solid in 70% yield.

### Synthesis of Intermediate C-2-NH₂

The synthetic route of intermediate **C-2-NH₂** is as follows: 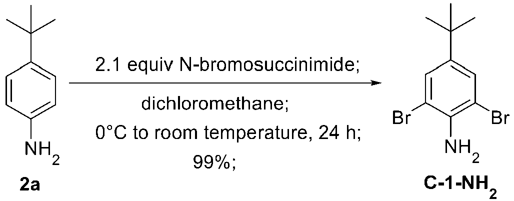 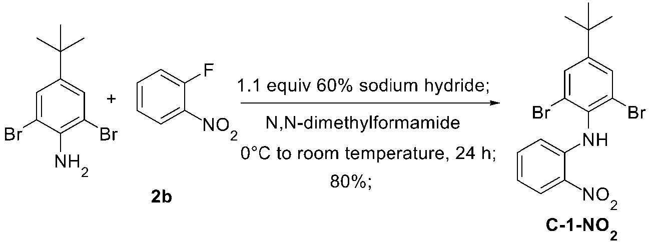 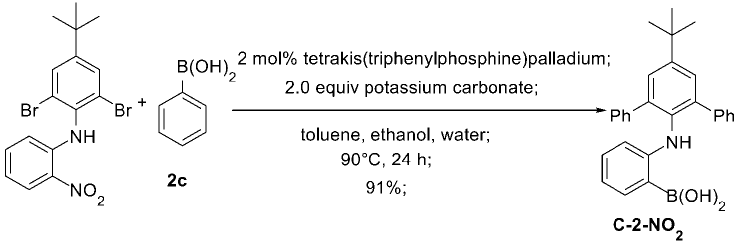 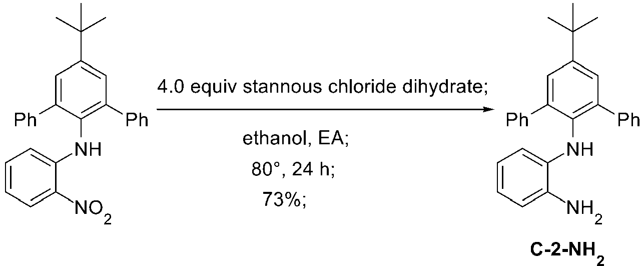
(1) Compound **2a** (20 g, 134.01 mmol, 1.0 equivalent) and dichloromethane (200 mL) are added into a single-necked flask equipped with a magnetic stir bar, stirring is performed until complete dissolution, and then the mixture is cooled to 0°C; N-bromosuccinimide (50.09 g, 281.42 mmol, 2.1 equivalents) is slowly added therein; then, the mixture is warmed to room temperature and stirred for reaction for 24 hours; then, sodium thiosulfate (3.32 g, 13.4 mmol, 0.1 equivalents) is added to quench the reaction; the reacted mixture is extracted three times with dichloromethane to collect respective organic layers, and the organic layers are combined to obtain an organic phase; distillation under reduced pressure is performed on the organic phase to remove a solvent therein, so as to obtain a crude product; and the crude product is purified by silica gel column chromatography (an eluent used therein being a mixture of petroleum ether and EA, and a volume ratio of the petroleum ether and the EA being 80:1) to afford 40.98 g of a red liquid in 99% yield.
(2) Compound **C-1-NH₂** (30 g, 97.71 mmol, 1.0 equivalent) and N,N-dimethylformamide (100 mL) are added into a single-necked flask equipped with a magnetic stir bar, stirring is performed until complete dissolution; then, the mixture is cooled to 0°C; 60 wt% sodium hydride (4.3 g, 107.48 mmol, 1.1 equivalents) is added therein, and stirring is performed for 30 minutes; then, compound **2b** (13.79 g, 97.71 mmol, 1.0 equivalent) is added therein, and the mixture is warmed to room temperature and stirred for reaction for 24 hours; then, deionized water is added therein to quench the reaction; the reacted mixture is extracted three times with dichloromethane to collect respective organic layers, and the organic layers are combined to obtain an organic phase; distillation under reduced pressure is performed on the organic phase to remove a solvent therein, so as to obtain a crude product; and the crude product is purified by silica gel column chromatography (an eluent used therein being a mixture of petroleum ether and dichloromethane, and a volume ratio of the petroleum ether and the dichloromethane being 6:1) to afford 33.48 g of a red oily substance in 80% yield.
(3) Compound **C-1-NO₂** (5 g, 11.68 mmol, 1.0 equivalent), compound **2c** (4.27 g, 35.04 mmol, 3.0 equivalents), tetrakis(triphenylphosphine)palladium (270 mg, 0.26 mmol, 2 mol%) and potassium carbonate (3.23 g, 23.36 mmol, 2.0 equivalents) are added into a three-necked flask equipped with a magnetic stir bar; then, the flask is purged with nitrogen three times, and toluene (30 mL), ethanol (10 mL) and water (10 mL) are added therein under a nitrogen atmosphere; the mixture is heated to 90°C for reaction for 24 hours and then cooled to room temperature; then, a solvent therein is removed by distillation under reduced pressure, so as to obtain a crude product; and the crude product is purified by silica gel column chromatography (an eluent used therein being a mixture of petroleum ether and EA, and a volume ratio of the petroleum ether and the EA being 40:1) to afford 4.52 g of a yellow solid in 91% yield.
(4) Compound **C-2-NO₂** (4.52 g, 10.7 mmol, 1.0 equivalent) and stannous chloride dihydrate (9.66 g, 42.8 mmol, 4.0 equivalents) are added into a three-necked flask equipped with a magnetic stir bar; then, the flask is purged with nitrogen three times, and EA (30 mL) and ethanol (30 mL) are added therein under a nitrogen atmosphere; the mixture is heated to 80°C for reaction for 24 hours and then cooled to room temperature; saturated sodium bicarbonate solution is added therein to quench the reaction; the reacted mixture is extracted three times with EA to collect respective organic layers, and the organic layers are combined to obtain an organic phase; distillation under reduced pressure is performed on the organic phase to remove a solvent therein, so as to obtain a crude product; and the crude product is purified by silica gel column chromatography (an eluent used therein being a mixture of petroleum ether and EA, and a volume ratio of the petroleum ether and the EA being 5:1) to afford 3.06 g of a yellow solid in 73% yield.

### Synthesis of Intermediate D-2-NH₂

The synthetic route of intermediate **D-2-NH₂** is as follows: 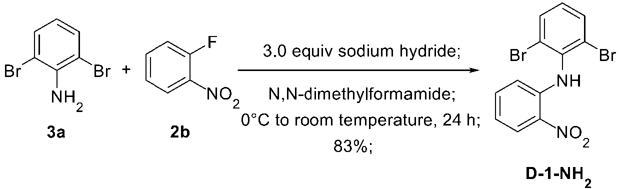 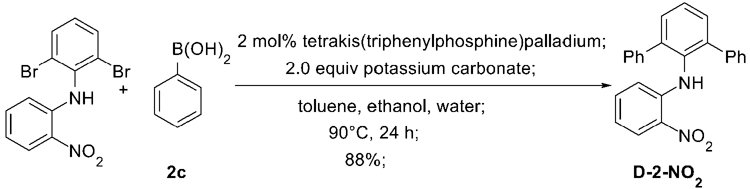 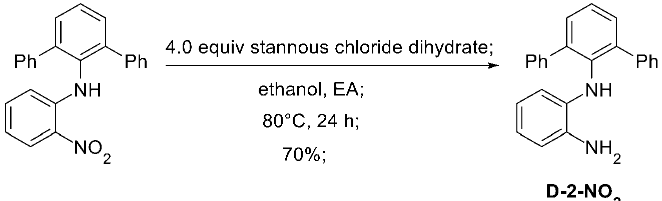
(1) Compound **3a** (24.52 g, 97.71 mmol, 1.0 equivalent) and N,N-dimethylformamide (100 mL) are added into a single-necked flask equipped with a magnetic stir bar, stirring is performed until complete dissolution, and then the mixture is cooled to 0°C; 60 wt% sodium hydride (4.3 g, 107.48 mmol, 1.1 equivalents) is slowly added therein; then, the mixture is warmed to room temperature and stirred for reaction for 24 hours; then, deionized water is added therein to quench the reaction; the reacted mixture is extracted three times with dichloromethane to collect respective organic layers, and the organic layers are combined to obtain an organic phase; distillation under reduced pressure is performed on the organic phase to remove a solvent therein, so as to obtain a crude product; and the crude product is purified by silica gel column chromatography (an eluent used therein being a mixture of petroleum ether and dichloromethane, and a volume ratio of the petroleum ether and the dichloromethane being 6:1) to afford 30.17 g of a red oily substance in 83% yield.
(2) Compound **D-1-NO₂** (4.35 g, 11.68 mmol, 1.0 equivalent), compound **2-b** (4.27 g, 35.04 mmol, 3.0 equivalents), tetrakis(triphenylphosphine)palladium (270 mg, 0.26 mmol, 2 mol%) and potassium carbonate (3.23 g, 23.36 mmol, 2.0 equivalents) are added into a three-necked flask equipped with a magnetic stir bar; then, the flask is purged with nitrogen three times, and toluene (30 mL), ethanol (10 mL) and water (10 mL) are added therein under a nitrogen atmosphere; the mixture is heated to 90°C for reaction for 24 hours and then cooled to room temperature; then, a solvent therein is removed by distillation under reduced pressure, so as to obtain a crude product; and the crude product is purified by silica gel column chromatography (an eluent used therein being a mixture of petroleum ether and EA, and a volume ratio of the petroleum ether and the EA being 40:1) to afford 3.77 g of a yellow solid in 88% yield.
(3) Compound **D-2-NO₂** (3.92 g, 10.7 mmol, 1.0 equivalent) and stannous chloride dihydrate (9.66 g, 42.8 mmol, 4.0 equivalents) are added into a three-necked flask equipped with a magnetic stir bar; then, the flask is purged with nitrogen three times, and EA (30 mL) and ethanol (30 mL) are added therein under a nitrogen atmosphere; the mixture is heated to 80°C for reaction for 24 hours and then cooled to room temperature; saturated sodium bicarbonate solution is added therein to quench the reaction; the reacted mixture is extracted three times with EA to collect respective organic layers, and the organic layers are combined to obtain an organic phase; distillation under reduced pressure is performed on the organic phase to remove a solvent therein, so as to obtain a crude product; and the crude product is purified by silica gel column chromatography (an eluent used therein being a mixture of petroleum ether and EA, and a volume ratio of the petroleum ether and the EA being 5:1) to afford 2.52 g of a yellow solid in 70% yield.

### Synthesis of Intermediate E-1-NH₂

The synthetic route of intermediate **E-1-NH₂** is as follows: 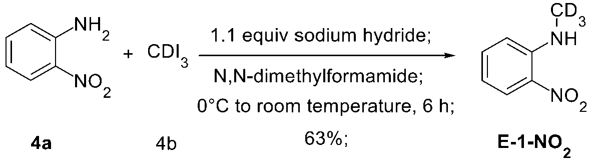 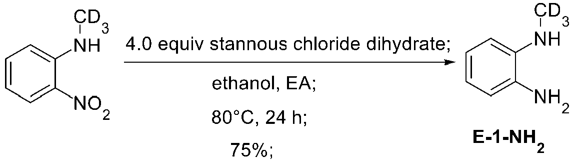
(1) Compound **4a** (2 g, 14.48 mmol, 1.0 equivalent) and N,N-dimethylformamide (20 mL) are added into a single-necked flask equipped with a magnetic stir bar, stirring is performed until complete dissolution, and then the mixture is cooled to 0°C; 60 wt% sodium hydride (636 mg, 14.94 mmol, 1.1 equivalents) is slowly added therein, and stirring is performed for 30 minutes; then, compound **4b** (2.17 g, 14.48 mmol, 1.0 equivalent) is added therein, and the mixture is warmed to room temperature and stirred for reaction for 24 hours; then, deionized water is added to quench the reaction; the reacted mixture is extracted three times with dichloromethane to collect respective organic layers, and the organic layers are combined to obtain an organic phase; distillation under reduced pressure is performed on the organic phase to remove a solvent therein, so as to obtain a crude product; and the crude product is purified by silica gel column chromatography (an eluent used therein being a mixture of petroleum ether and dichloromethane, and a volume ratio of the petroleum ether and the dichloromethane being 6:1) to afford 1.42 g of a red oily substance in 63% yield.
(2) Compound **E-2-NO₂** (1.42 g, 9.15 mmol, 1.0 equivalent) and stannous chloride dihydrate (8.26 g, 36.6 mmol, 4.0 equivalents) are added into a three-necked flask equipped with a magnetic stir bar; then, the flask is purged with nitrogen three times, and EA (20 mL) and ethanol (10 mL) are added therein under a nitrogen atmosphere; the mixture is heated to 80°C for reaction for 24 hours and then cooled to room temperature; saturated sodium bicarbonate solution is added therein to quench the reaction; the reacted mixture is extracted three times with EA to collect respective organic layers, and the organic layers are combined to obtain an organic phase; distillation under reduced pressure is performed on the organic phase to remove a solvent therein, so as to obtain a crude product; and the crude product is purified by silica gel column chromatography (an eluent used therein being a mixture of petroleum ether and EA, and a volume ratio of the petroleum ether and the EA being 5:1) to afford 859 mg of a black oily substance in 75% yield.

It will be noted that the above merely presents feasible preparation methods for the intermediates in the present disclosure. Intermediates required for each embodiment may be prepared by referring to the synthesis process of the intermediates **A-1-OH, A-2-Cl** and **E-1-NH₂.** However, the preparation of this type of intermediate compounds is not limited to the above methods. That is, the preparation of this type of intermediate compounds may be carried out by using the methods listed above or by using other methods known in the art. The synthesis process of the intermediates above is not intended to limit the scope of protection of the present disclosure.

### Embodiment 1: Synthesis of Pt-1

The synthetic route of a tetradentate cyclometalated platinum(II) complex phosphorescent material **Pt-1** is as follows:

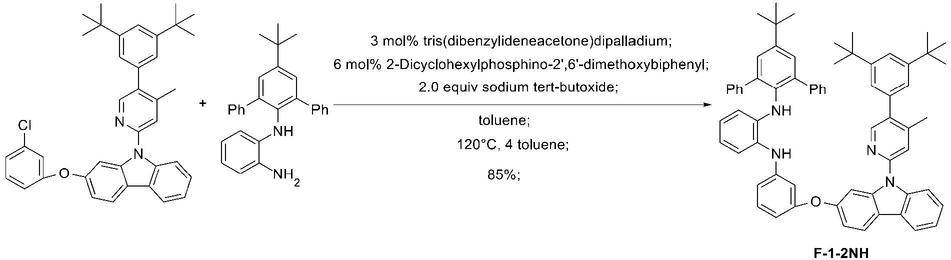

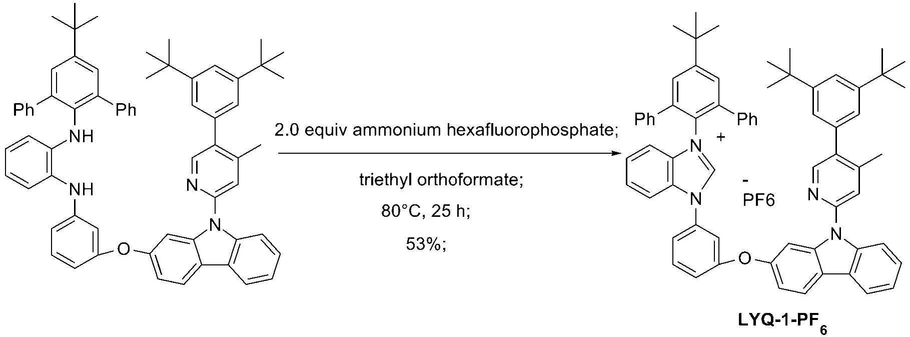

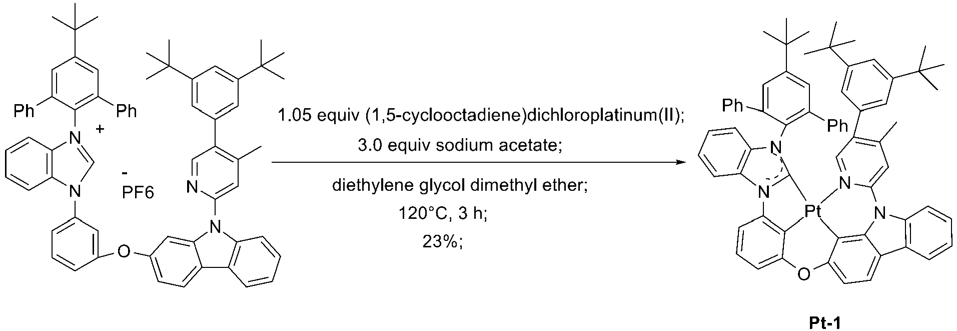

**Synthesis of Intermediate F-1-2NH** Intermediate **A-2-Cl** (200 mg, 0.35 mmol, 1.0 equivalent), intermediate **C-2-NH₂** (137 mg, 0.35 mmol, 1.0 equivalent), tris(dibenzylideneacetone)dipalladium (10 mg, 0.01 mmol, 3 mol%), 2-Dicyclohexylphosphino-2',6'-dimethoxybiphenyl (8 mg, 0.02 mmol, 6 mol%) and sodium tert-butoxide (67 mg, 0.7 mmol, 2.0 equivalents) are added into a three-necked flask equipped with a magnetic stir bar; then, the flask is purged with nitrogen three times, and toluene (10 mL) is added therein under a nitrogen atmosphere; the mixture is heated to 120°C for reaction for 4 hours and then cooled to room temperature; then, a solvent therein is removed by distillation under reduced pressure, so as to obtain a crude product; and the crude product is purified by silica gel column chromatography (an eluent used therein being a mixture of petroleum ether and EA, and a volume ratio of the petroleum ether and the EA being 20:1) to afford 277 mg of a yellow solid in 85% yield.

Synthesis of Ligand **LYQ-1-PF₆:** Intermediate **F-1-2NH** (277 mg, 0.3 mmol, 1.0 equivalent) and ammonium hexafluorophosphate (98 mg, 0.6 mmol, 2.0 equivalents) are added into a three-necked flask equipped with a magnetic stir bar; then, the flask is purged with nitrogen three times, and triethyl orthoformate (5 mL) is added therein under a nitrogen atmosphere; the mixture is heated to 80°C for reaction for 25 minutes and then cooled to room temperature; then, a solvent therein is removed by distillation under reduced pressure, so as to obtain a crude product; and the crude product is purified by silica gel column chromatography (an eluent used therein being a mixture of dichloromethane and EA, and a volume ratio of the dichloromethane and the EA being 40:1) to afford 173 mg of a yellow solid in 53% yield.

Synthesis of **Pt-1:** Ligand **LYQ-1-PF₆** (177 mg, 0.16 mmol, 1.0 equivalent), (1,5-cyclooctadiene)dichloroplatinum(II) (64 mg, 0.17 mmoL, 1.05 equivalents) and sodium acetate (39 mg, 0.48 mmol, 3.0 equivalents) are added into a flask equipped with a magnetic stir bar; then, the flask is purged with nitrogen three times, and diethylene glycol dimethyl ether (5 mL) is added therein under a nitrogen atmosphere; the mixture is heated to 120°C for reaction with stirring for 3 days and then cooled to room temperature; then, a solvent therein is removed by distillation under reduced pressure, so as to obtain a crude product; and the crude product is purified by silica gel column chromatography (an eluent used therein being a mixture of petroleum ether and dichloromethane, and a volume ratio of the petroleum ether and the dichloromethane being 2:1) to afford 42 mg of a cyan solid in 23% yield. A ¹H NMR characterization result for the cyan solid is as follows: ¹H NMR (500 MHz, DMSO-*d₆*) δ 9.00 (s, 1H), 8.22 (d, *J*=5 Hz, 1H), 8.17 (d, *J=10* Hz, 1H), 8.11 (d, *J=10* Hz, 1H), 7.99 (s, 1H), 7.85 (d, *J*=5 Hz, 1H), 7.63 (t, *J*=15 Hz, 1H), 7.58 (d, *J=10* Hz, 1H), 7.49-7.45 (m, 2H), 7.37 (d, *J*=5 Hz, 1H), 7.25 (d, *J*=15 Hz, 1H), 7.18-7.11 (m, 5H), 7.03 (d, *J*=15 Hz, 1H), 6.96 (s, 3H), 6.89 (d, *J*=10 Hz, 1H). 6.77 (d, *J*=5 Hz, 3H), 6.47 (t, *J*=15 Hz, 3H), 6.03 (t, *J*=15 Hz, 2H), 2.05 (s, 3H), 1.50 (s, 9H), 1.14 (s, 18H).

### Embodiment 2: Synthesis of Pt-2

The synthetic route of the tetradentate cyclometalated platinum(II) complex phosphorescent material **Pt-2** is as follows:

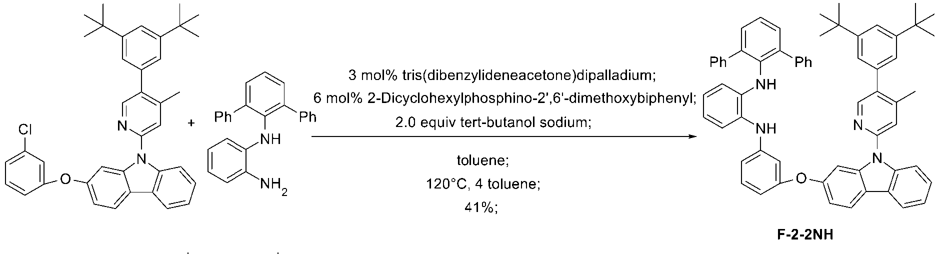

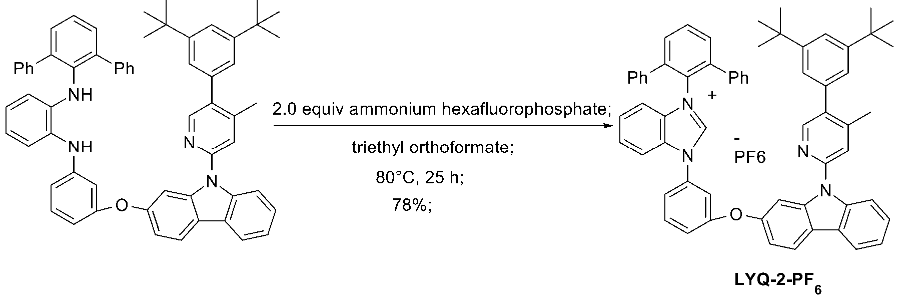

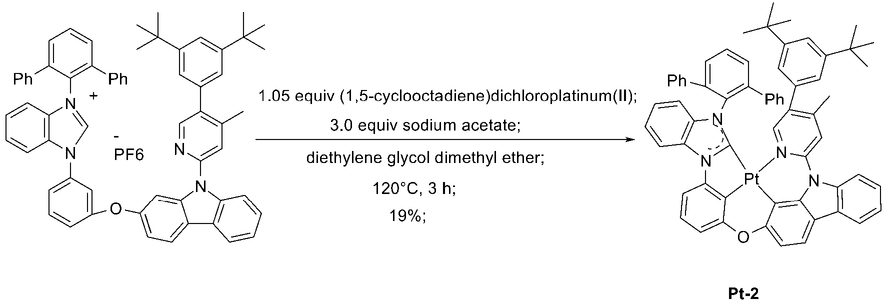

**Synthesis of Intermediate F-2-2NH** Intermediate **A-2-Cl** (250 mg, 0.44 mmol, 1.0 equivalent), intermediate **D-2-NH₂** (148 mg, 0.44 mmol, 1.0 equivalent), tris(dibenzylideneacetone)dipalladium (10 mg, 0.01 mmol, 3 mol%), 2-Dicyclohexylphosphino-2',6'-dimethoxybiphenyl (8 mg, 0.02 mmol, 6 mol%) and tert-butanol sodium (85 mg, 0.88 mmol, 2.0 equivalents) are added into a three-necked flask equipped with a magnetic stir bar; then, the flask is purged with nitrogen three times, and toluene (10 mL) is added therein under a nitrogen atmosphere; the mixture is heated to 120°C for reaction for 4 hours and then cooled to room temperature; then, a solvent therein is removed by distillation under reduced pressure, so as to obtain a crude product; and the crude product is purified by silica gel column chromatography (an eluent used therein being a mixture of petroleum ether and EA, and a volume ratio of the petroleum ether and the EA being 20:1) to afford 158 mg of a yellow solid in 41% yield.

Synthesis of Ligand **LYQ-2-PF₆:** Intermediate **F-2-2NH** (158 mg, 0.18 mmol, 1.0 equivalent) and ammonium hexafluorophosphate (59 mg, 0.36 mmol, 2.0 equivalents) are added into a three-necked flask equipped with a magnetic stir bar; then, the flask is purged with nitrogen three times, and triethyl orthoformate (5 mL) is added therein under a nitrogen atmosphere; the mixture is heated to 80°C for reaction for 25 minutes and then cooled to room temperature; then, a solvent therein is removed by distillation under reduced pressure, so as to obtain a crude product; and the crude product is purified by silica gel column chromatography (an eluent used therein being a mixture of dichloromethane and EA, and a volume ratio of the dichloromethane and the EA being 40:1) to afford 144 mg of a yellow solid in 78% yield.

Synthesis of **Pt-2:** Ligand **LYQ-2-PF₆** (144 mg, 0.14 mmol, 1.0 equivalent), (1,5-cyclooctadiene)dichloroplatinum(II) (56 mg, 0.15 mmol, 1.05 equivalents) and sodium acetate (34 mg, 0.42 mmol, 3.0 equivalents) are added into the a flask equipped with a magnetic stir bar; then, the flask is purged with nitrogen three times, and diethylene glycol dimethyl ether (5 mL) is added therein under a nitrogen atmosphere; the mixture is heated to 120°C for reaction with stirring for 3 days and then cooled to room temperature; then, a solvent therein is removed by distillation under reduced pressure, so as to obtain a crude product; and the crude product is purified by silica gel column chromatography (an eluent used therein being a mixture of petroleum ether and dichloromethane, and a volume ratio of the petroleum ether and the dichloromethane being 2:1) to afford 31 mg of a cyan solid in 19% yield. A ¹H NMR characterization result for the cyan solid is as follows: ¹H NMR (500 MHz, DMSO-*d₆*) δ 8.77 (s, 1H), 8.30 (d, *J=10* Hz, 1H), 8.16 (dd, *J*=10, 5 Hz, 2H), 8.00 (s, 1H), 7.80 (d, *J=10* Hz, 1H), 7.63 (s, 2H), 7.57 (t, *J*=5 Hz, 1H), 7.46 (t, *J=10* Hz, 1H), 7.41 (d, *J*=5 Hz, 1H), 7.26-7.19 (m, 4H), 7.16 (dd, *J*=10, 5 Hz, 3H), 7.08-7.01 (m, 4H), 6.97 (dd, *J*=15, 10 Hz, 4H), 6.77 (d, *J=10* Hz, 1H), 6.68 (d, *J*=5 Hz, 2H), 6.65-6.59 (m, 2H), 2.28 (s, 3H), 1.15 (s, 18H).

### Embodiment 3: Synthesis of Pt-3

The synthetic route of the tetradentate cyclometalated platinum(II) complex phosphorescent material **Pt-3** is as follows:

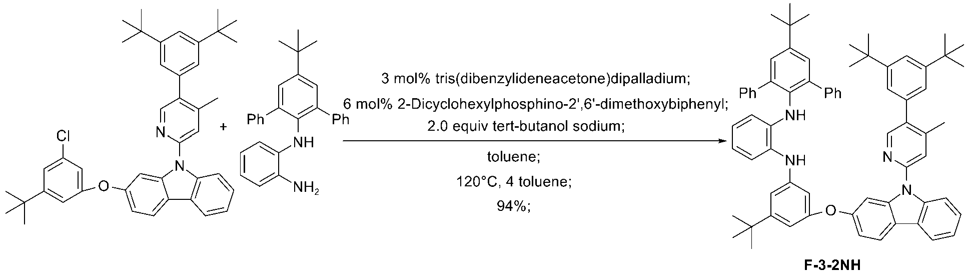

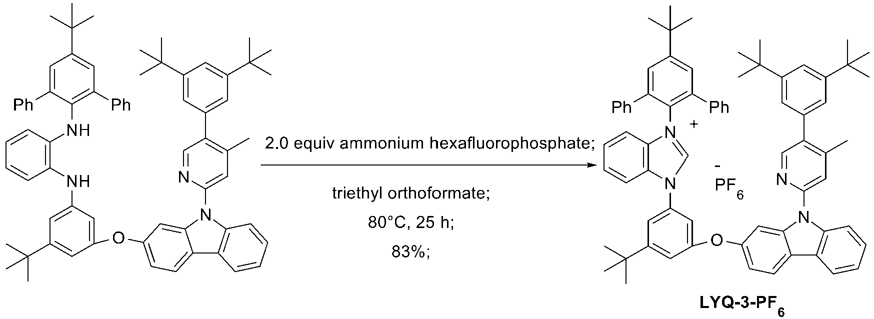

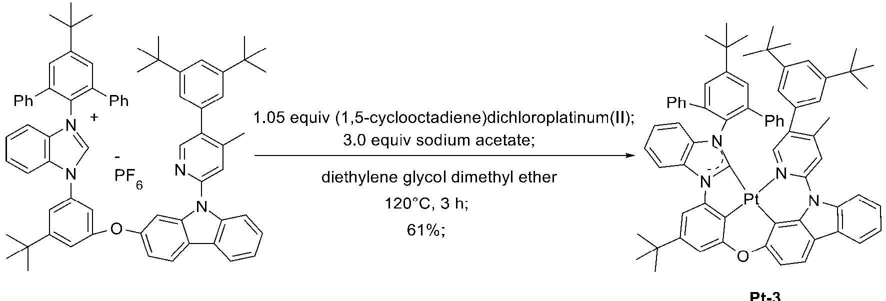

**Synthesis of Intermediate F-3-2NH:** Intermediate **A-3-Cl** (300 mg, 0.65 mmol, 1.0 equivalent), intermediate **C-2-NH₂** (255 mg, 0.65 mmol, 1.0 equivalent), tris(dibenzylideneacetone)dipalladium (18 mg, 0.02 mmol, 3 mol%), 2-Dicyclohexylphosphino-2',6'-dimethoxybiphenyl (16 mg, 0.04 mmol, 6 mol%) and tert-butanol sodium (125 mg, 1.3 mmol, 2.0 equivalents) are added into a three-necked flask equipped with a magnetic stir bar; then, the flask is purged with nitrogen three times, and toluene (10 mL) is added therein under a nitrogen atmosphere; the mixture is heated to 120°C for reaction for 4 hours and then cooled to room temperature; then, a solvent therein is removed by distillation under reduced pressure, so as to obtain a crude product; and the crude product is purified by silica gel column chromatography (an eluent used therein being a mixture of petroleum ether and EA, and a volume ratio of the petroleum ether and the EA being 20:1) to afford 441 mg of a yellow solid in 94% yield.

Synthesis of Ligand **LYQ-3-PF₆:** Intermediate **F-3-2NH** (441 mg, 0.45 mmol, 1.0 equivalent) and ammonium hexafluorophosphate (147 mg, 0.9 mmol, 2.0 equivalents) are added into a three-necked flask equipped with a magnetic stir bar; then, the flask is purged with nitrogen three times, and triethyl orthoformate (5 mL) is added therein under a nitrogen atmosphere; the mixture is heated to 80°C for reaction for 25 minutes and then cooled to room temperature; then, a solvent therein is removed by distillation under reduced pressure, so as to obtain a crude product; and the crude product is purified by silica gel column chromatography (an eluent used therein being a mixture of dichloromethane and EA, and a volume ratio of the dichloromethane and the EA being 40:1) to afford 426 mg of a yellow solid in 83% yield.

Synthesis of **LYQ-3-Pt:** Ligand **LYQ-3-PF₆** (250 mg, 0.22 mmol, 1.0 equivalent), (1,5-cyclooctadiene)dichloroplatinum(II) (85 mg, 0.23 mmol, 1.05 equivalents) and sodium acetate (53 mg, 0.66 mmol, 3.0 equivalents) are added into a flask equipped with a magnetic stir bar; then, the flask is purged with nitrogen three times, and diethylene glycol dimethyl ether (10 mL) is added therein under a nitrogen atmosphere; the mixture is heated to 120°C for reaction with stirring for 3 days and then cooled to room temperature; then, a solvent therein is removed by distillation under reduced pressure, so as to obtain a crude product; and the crude product is purified by silica gel column chromatography (an eluent used therein being a mixture of petroleum ether and dichloromethane, and a volume ratio of the petroleum ether and the dichloromethane being 2:1) to afford 158 mg of a cyan solid in 61% yield. A¹H NMR characterization result for the cyan solid is as follows: ¹H NMR (500 MHz, DMSO-*d₆*) δ 8.98 (s, 1H), 8.22 (d, *J*=5 Hz, 1H), 8.10 (t, *J=10* Hz, 2H), 7.98 (s, 1H), 7.84 (d, *J*=5 Hz, 1H), 7.63 (t, *J=10* Hz, 1H), 7.50-7.44 (m, 3H), 7.37 (d, *J*=5 Hz, 1H), 7.29 (t, *J=10* Hz, 1H), 7.17-7.13 (m, 4H), 7.05 (t, *J=10* Hz, 1H), 6.98-6.95 (m, 3H), 6.90 (d, *J*=5 Hz, 1H), 6.79 (d, *J*=10 Hz, 3H), 6.54-6.44 (m, 3H), 6.05 (t, *J=10* Hz, 2H), 2.05 (s, 3H), 1.50 (s, 10H), 1.41 (s, 10H), 1.13 (s, 20H).

### Embodiment 4: Synthesis of Pt-24

The synthetic route of the tetradentate cyclometalated platinum(II) complex phosphorescent material **Pt-24** is as follows:

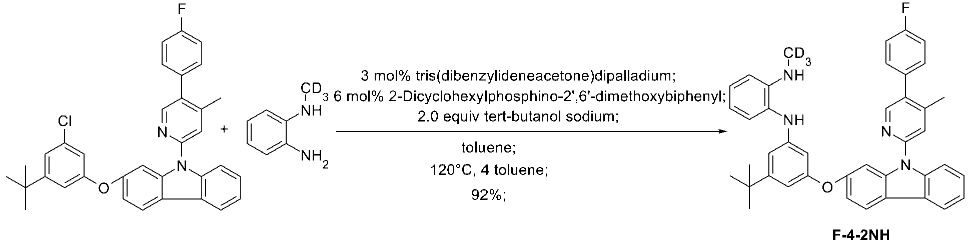

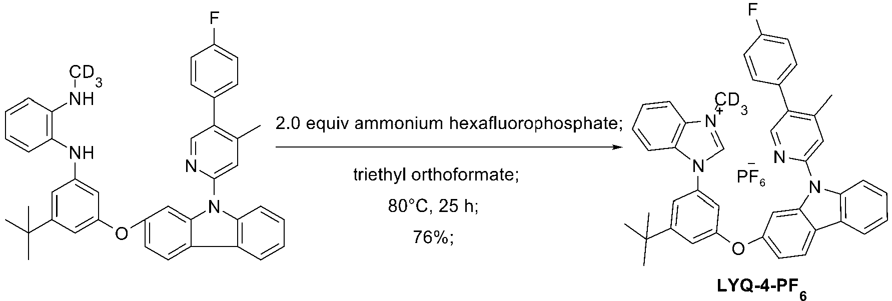

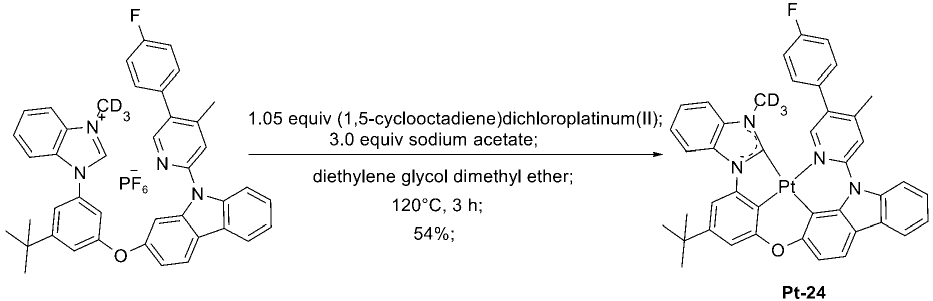

**Synthesis of Intermediate F-4-2NH** Intermediate **A-2-Cl** (250 mg, 0.44 mmol, 1.0 equivalent), intermediate **D-2-NH₂** (148 mg, 0.44 mmol, 1.0 equivalent), tris(dibenzylideneacetone)dipalladium (10 mg, 0.01 mmol, 3 mol%), 2-Dicyclohexylphosphino-2',6'-dimethoxybiphenyl (8 mg, 0.02 mmol, 6 mol%) and tert-butanol sodium (85 mg, 0.88 mmol, 2.0 equivalents) are added into a three-necked flask equipped with a magnetic stir bar; then, the flask is purged with nitrogen three times, and toluene (10 mL) is added therein under a nitrogen atmosphere; the mixture is heated to 120°C for reaction for 4 hours and then cooled to room temperature; then, a solvent therein is removed by distillation under reduced pressure, so as to obtain a crude product; and the crude product is purified by silica gel column chromatography (an eluent used therein being a mixture of petroleum ether and EA, and a volume ratio of the petroleum ether and the EA being 20:1) to afford 158 mg of a yellow solid in 41% yield.

Synthesis of Ligand **LYQ-4-PF₆:** Intermediate **F-2-2NH** (158 mg, 0.18 mmol, 1.0 equivalent) and ammonium hexafluorophosphate (59 mg, 0.36 mmol, 2.0 equivalents) are added into a three-necked flask equipped with a magnetic stir bar; then, the flask is purged with nitrogen three times, and triethyl orthoformate (5 mL) is added therein under a nitrogen atmosphere; the mixture is heated to 80°C for reaction for 25 minutes and then cooled to room temperature; then, a solvent therein is removed by distillation under reduced pressure, so as to obtain a crude product; and the crude product is purified by silica gel column chromatography (an eluent used therein being a mixture of dichloromethane and EA, and a volume ratio of the dichloromethane and the EA being 40:1) to afford 144 mg of a yellow solid in 78% yield.

Synthesis of **Pt-24:** Ligand **LYQ-4-PF₆** (200 mg, 0.26 mmol, 1.0 equivalent), (1,5-cyclooctadiene)dichloroplatinum(II) (101 mg, 0.27 mmol, 1.05 equivalents) and sodium acetate (64 mg, 0.78 mmol, 3.0 equivalents) are added into a flask equipped with a magnetic stir bar; then, the flask is purged with nitrogen three times, and diethylene glycol dimethyl ether (10 mL) is added therein under a nitrogen atmosphere; the mixture is heated to 120°C for reaction with stirring for 3 days and then cooled to room temperature; then, a solvent therein is removed by distillation under reduced pressure, so as to obtain a crude product; and the crude product is purified by silica gel column chromatography (an eluent used therein being a mixture of petroleum ether and dichloromethane, and a volume ratio of the petroleum ether and the dichloromethane being 2:1) to afford 116 mg of a cyan solid in 54% yield. A¹H NMR characterization result for the cyan solid is as follows: ¹H NMR (500 MHz, DMSO-*d₆*) δ 9.30 (s, 1H), 8.23 (d, *J=10* Hz, 1H), 8.19-8.14 (m, 3H), 7.90 (d, *J*=15 Hz, 1H), 7.71 (d, *J*=5 Hz, 1H), 7.57 (s, 1H), 7.55-7.49 (m, 4H), 7.42 (dt, *J*=20, 5 Hz, 2H), 7.34-7.26 (m, 3H), 6.98 (s, 1H), 2.30 (s, 3H), 1.44 (s, 9H).

### Embodiment 5: Synthesis of Pt-8

**Pt-8** is synthesized with reference to the steps and reaction conditions for synthesizing compound **Pt-1.** A target product is obtained as a yellow solid (562 mg, 70% yield). MS (ESI) *m*/*z:* [M+H]⁺ 866.33.

### Embodiment 6: Synthesis of Pt-31

**Pt-31** is synthesized with reference to the steps and reaction conditions for synthesizing compound **Pt-1.** A target product is obtained as a yellow solid (624 mg, 56% yield). MS (ESI) *m*/*z:* [M+H]⁺ 1018.40.

### Embodiment 7: Synthesis of Pt-37

**Pt-37** is synthesized with reference to the steps and reaction conditions for synthesizing compound **Pt-1.** A target product is obtained as a yellow solid (661 mg, 82% yield). MS (ESI) *m*/*z:* [M+H]⁺ 1074.46.

### Embodiment 8: Synthesis of Pt-65

**Pt-65** is synthesized with reference to the steps and reaction conditions for synthesizing compound **Pt-1.** A target product is obtained as a yellow solid (484 mg, 67% yield). MS (ESI) *m*/*z:* [M+H]⁺cc 1186.58.

### Embodiment 9: Synthesis of Pt-81

**Pt-81** is synthesized with reference to the steps and reaction conditions for synthesizing compound **Pt-1.** A target product is obtained as a yellow solid (455 mg, 60% yield). MS (ESI) *m*/*z:* [M+H]⁺ 1037.44.

### Embodiment 10: Synthesis of Pt-174

**Pt-174** is synthesized with reference to the steps and reaction conditions for synthesizing compound **Pt-1.** A target product is obtained as a yellow solid (410 mg, 66% yield). MS (ESI) *m*/*z:* [M+H]⁺ 1279.57.

### Embodiment 11: Synthesis of Pt-183

**Pt-183** is synthesized with reference to the steps and reaction conditions for synthesizing compound **Pt-1.** A target product is obtained as a yellow solid (492 mg, 82% yield). MS (ESI) *m*/*z:* [M+H]⁺ 1203.53.

### Embodiment 12: Synthesis of Pt-241

**Pt-241** is synthesized with reference to the steps and reaction conditions for synthesizing compound **Pt-1.** A target product is obtained as a yellow solid (467 mg, 72% yield). MS (ESI) *m*/*z:* [M+H]⁺ 1065.48.

### Embodiment 13: Synthesis of Pt-256

**Pt-256** is synthesized with reference to the steps and reaction conditions for synthesizing compound **Pt-1.** A target product is obtained as a yellow solid (528 mg, 68% yield). MS (ESI) *m*/*z:* [M+H]⁺ 924.41.

### Embodiment 14: Synthesis of Pt-273

**Pt-273** is synthesized with reference to the steps and reaction conditions for synthesizing compound **Pt-1.** A target product is obtained as a yellow solid (436 mg, 49% yield). MS (ESI) *m*/*z:* [M+H]⁺ 1166.52.

### Photophysical Properties:

**Table 1. Photophysical Properties of Selected Metal Complexes in Dichloromethane Solution**

| **Complex** | **Maximum Emission Wavelength** | **Full Width at Half Maximum** |
|---|---|---|
| **Pt-1** | 455.8 nm | 19.4 nm |
| **Pt-2** | 456.2 nm | 21.2 nm |
| **Pt-24** | 460.6 nm | 39.6 nm |
| **Pt-37** | 457.4 nm | 33.8 nm |

FIG.1 shows emission spectra of compounds **Pt-1** to **Pt-4** in a dichloromethane solution at room temperature. As can be seen from FIG. 1 and Table 1, the emission wavelengths corresponding to the metal complexes provided in the present disclosure all fall within blue and deep-blue light emission regions, and the metal complexes provided in the present disclosure achieve high color purity and a narrow full width at half maximum, and thus are excellent blue phosphorescent materials.

### Fabrication of OLED Devices:

A reference fabrication method for device examples in the present disclosure includes the following steps: on a surface of an indium-tin-oxide (ITO) glass substrate with a light-emitting area of 2 mm×2 mm or on an anode, vapor-depositing a p-type doped material or co-depositing a p-type doped material at a concentration of 1% to 50% by mass with a hole injection material to form a hole injection layer (HIL) with a thickness of 5 nm to 100 nm; forming a hole transport layer (HTL) with a thickness of 5 nm to 200 nm; forming a light-emitting layer (EML) (which may contain the compound described in the present disclosure) with a thickness of 10 nm 100 nm on the HTL; and forming an electron transport layer (ETL) with a thickness of 20 nm to 200 nm and a cathode with a thickness of 50 nm 200 nm. If necessary, an electron blocking layer (EBL) is introduced between the HTL and the EML, and an electron injection layer (EIL) is introduced between the ETL and the cathode. Thus, an OLED device is fabricated. OLED devices are tested by using standard methods. Unless otherwise specified, the materials for fabricating the devices in the present disclosure can be obtained through known synthesis methods.

In a preferred embodiment of the present disclosure, a structure of Device Example 1 is as follows: ITO/P-4 (10 nm)/NPD (60 nm)/HTH-85 (5 nm)/platinum (II) complex: HTH-85:ETH-45 (25 nm) (Pt-1:HTH-85:ETH-45 with a mass ratio of 10:60:30)/ETH-5 (5 nm)/ET-14 (40 nm)/ Lithium 8-hydroxyquinolinate (LiQ) (1 nm)/Al (100 nm).

Devices in Device Examples 2 to 14 and Comparative Example 1 are fabricated by using structures similar to that of the device in Device Example 1, differing only in that **Pt-1** in Device Example 1 is substituted with **Pt-2, Pt-3, Pt-8, Pt-24, Pt-31, Pt-37, Pt-65, Pt-81, Pt-174, Pt-183, Pt-241, Pt-256, Pt-273** in Device Examples 2 to 14, respectively, and with **R1** in Comparative Example 1. The light-emitting characteristics of the fabricated devices in comparative example and the device examples are tested by using standard methods; and the data are presented in Table 2. Structural formulas of the involved compounds are as follows, **P-4** denoting HATCN, **ET-14** denoting BPyTP.

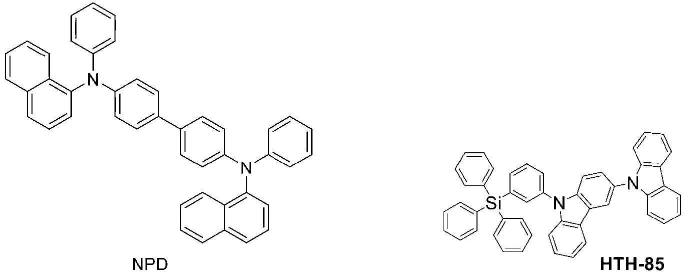

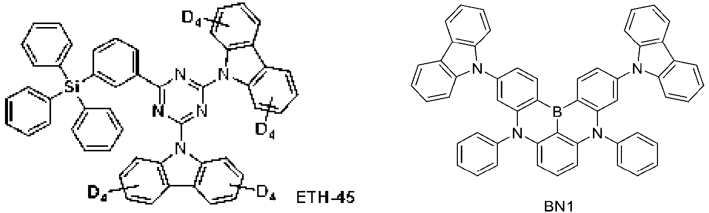

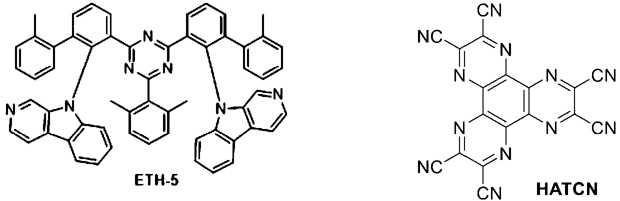

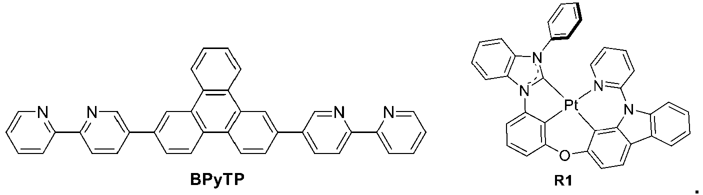

**Table 2. Device Luminescence Characteristics Data Sheet**

| Example | Light-Emitting Layer | Drive Voltage (Volt) @ 10 mA/cm² (Relative Value, %) | Current Efficiency (cd/A) @1000 cd/m² (Relative Value, %) | Device Lifetime (h) @1000 cd/m² (Relative Value, %) |
|---|---|---|---|---|
| Comparative Example 1 | **R1** | 100 | 100 | 100 |
| Device Example 1 | **Pt-1** | 96 | 135 | 157 |
| Device Example 2 | **Pt-2** | 97 | 137 | 160 |
| Device Example 3 | **Pt-3** | 95 | 133 | 158 |
| Device Example 4 | **Pt-8** | 96 | 143 | 162 |
| Device Example 5 | **Pt-24** | 96 | 135 | 158 |
| Device Example 6 | **Pt-31** | 95 | 142 | 161 |
| Device Example 7 | **Pt-37** | 94 | 142 | 158 |
| Device Example 8 | **Pt-65** | 96 | 136 | 158 |
| Device Example 9 | **Pt-81** | 94 | 134 | 153 |
| Device Example 10 | **Pt-174** | 95 | 135 | 157 |
| Device Example 11 | **Pt-183** | 95 | 139 | 159 |
| Device Example 12 | **Pt-241** | 95 | 137 | 155 |
| Device Example 13 | **Pt-256** | 96 | 132 | 155 |
| Device Example 14 | **Pt-273** | 94 | 140 | 161 |

It can be seen from Table 2 that, compared with Comparative Example 1, Device Examples 1 to 14 fabricated in the present disclosure demonstrate superior device performance in terms of drive voltage, current efficiency and device lifetime. The performance improvements of the device examples are based on the superior electron transport capabilities of the specific compound materials provided in the present disclosure. It can be seen that, when the compound materials of the present disclosure are each used as a material of a light-emitting layer of an electronic device, a drive voltage may be reduced, and current efficiency and device lifetime may also be improved. In addition, the devices fabricated in the present disclosure are all deep blue light-emitting devices, with CIEy values all below 0.19. This indicates that the compounds provided in the present disclosure possess certain commercial application value.

In a preferred embodiment of the present disclosure, a structure of Device Example 15 is as follows: ITO/P-4 (10 nm)/NPD (60 nm)/HTH-85 (5 nm)/platinum (II) complex: boron-containing compound:HTH-85:ETH-45 (25 nm) (Pt-1:BN1:HTH-85:ETH-45 with a mass ratio of 10:1:59:30)/ETH-5 (5 nm)/ET-14 (40 nm)/LiQ (1 nm)/Al (100 nm).

Device Examples 16 to 18 and Comparative Example 2 are fabricated by using structures similar to that of Device Example 11, differing only in that respectively using compounds listed in Table 3 to replace the platinum(II) complex and the boron-containing compound in Device Example 15. The device structure and luminescence characteristics data is shown in Table 3.

**Table 3. Device Structure and Luminescence Characteristics Data Sheet**

| Example | Platinum(II) Complex:Boron-Containing Compound | Drive Voltage (Volt) @ 10 mA/cm² (Relative Value, %) | Current Efficiency (cd/A) @1000 cd/m² (Relative Value, %) | Device Lifetime (h) @1000 cd/m² (Relative Value, %) |
|---|---|---|---|---|
| Comparative Example 2 | **R1:BN1** | 100 | 100 | 100 |
| Device Example 15 | **Pt-1:BN1** | 96 | 132 | 155 |
| Device Example 16 | **Pt-8:BN1** | 95 | 140 | 162 |
| Device Example 17 | **Pt-37:BN1** | 96 | 137 | 153 |
| Device Example 18 | **Pt-183:BN1** | 95 | 136 | 154 |

It can be seen from Table 3 that, when the compounds of the present disclosure, which are used as sensitizing materials, and the boron-containing compounds are co-used as light-emitting materials in devices, the performances of the devices are also significantly enhanced. This further indicates that the compounds provided in the present disclosure possess certain commercial application value. In addition, a sensitized device structure that incorporates a boron-containing compound may further reduce a CIEy value, thereby further improving a color purity of emitted light of a device.

The applicant declares that the foregoing description constitutes only specific embodiments of the present disclosure, but the scope of protection of the present disclosure is not limited thereto. Those skilled in the art shall understand that any modifications or substitutions readily conceivable to a person skilled in the art within the technical scope disclosed by the present disclosure fall within the scope of protection and disclosure of the present disclosure.

## Claims

1. A phenylpyridine-based tetradentate cyclometalated platinum (II) complex, **characterized in that**, the complex has a structure as shown in formula (I): 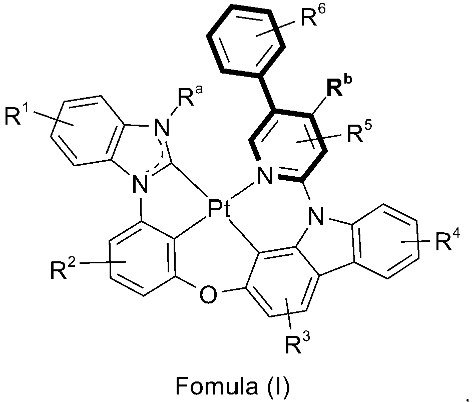
wherein in formula (I), R¹-R⁶ each independently represent from mono to maximum allowable substitution, or no substitution; and R¹-R⁶ are each independently selected from the group consisting of: hydrogen, deuterium (D), halogen, C1-C30 alkyl, C1-C30 haloalkyl, substituted or unsubstituted C6-C60 aryl, and combinations thereof; and
R^{a} and R^{b} are each independently selected from the group consisting of: hydrogen, deuterium, C1-C30 alkyl, substituted or unsubstituted C6-C60 aryl, and combinations thereof; and a substituent on each substituted C6-C60 aryl is deuterium, C1-C30 alkyl or C6-C60 aryl.

2. The tetradentate cyclometalated platinum (II) complex according to claim 1, **characterized in that**, R^{a} is selected from hydrogen, deuterium, CD₃, C1-C10 alkyl, C6-C30 aryl, and combinations thereof; and R^{b} is selected from hydrogen, deuterium, C1-C20 alkyl, and combinations thereof.

3. The tetradentate cyclometalated platinum (II) complex according to claim **1, characterized in that**, R¹-R⁶ are each independently selected from hydrogen, deuterium, CD₃, F, CF₃, methyl, ethyl, propyl, isopropyl, butyl, tert-butyl, pentyl, hexyl, heptyl, phenyl, and combinations thereof.

4. The tetradentate cyclometalated platinum (II) complex according to claim **1, characterized in that**, the tetradentate cyclometalated platinum (II) complex is any one selected from chemical structures shown below, wherein D represents deuterium:

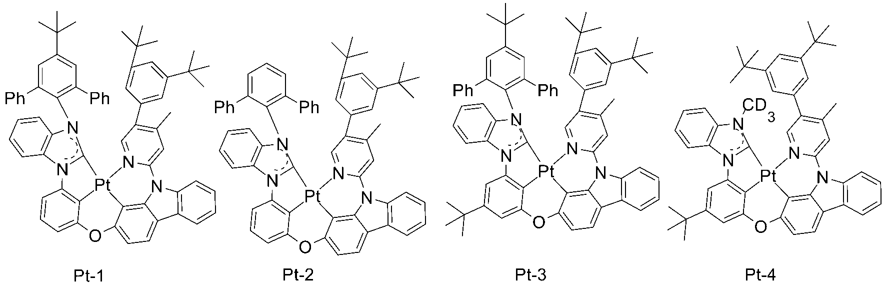

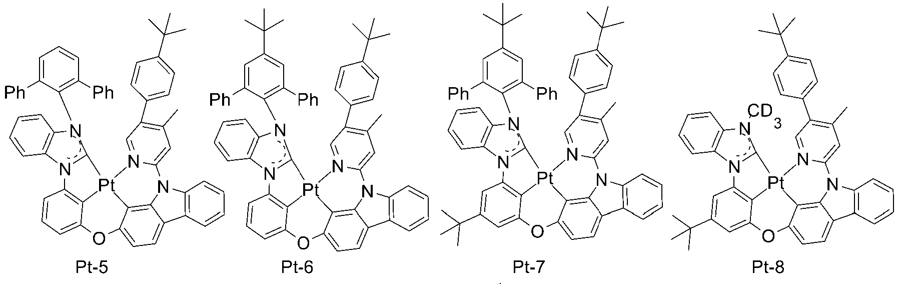

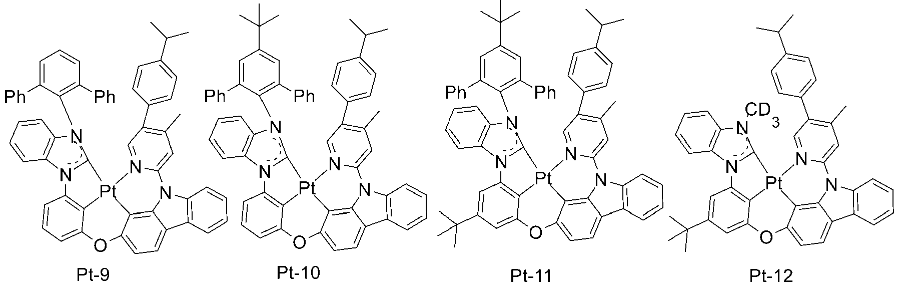

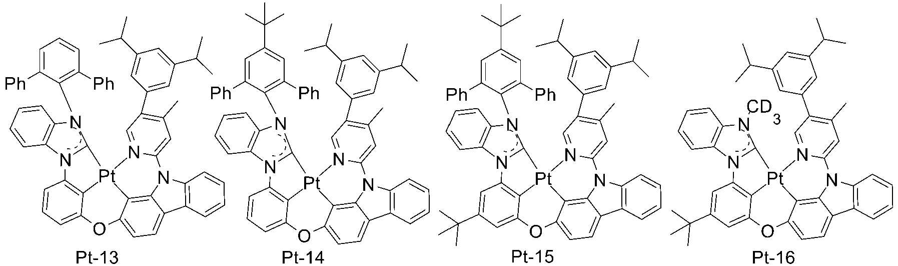

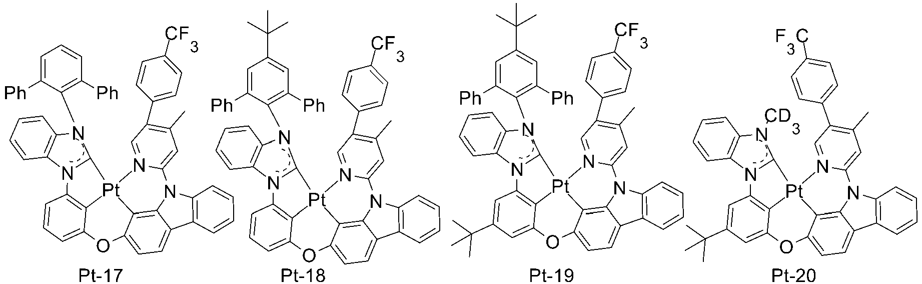

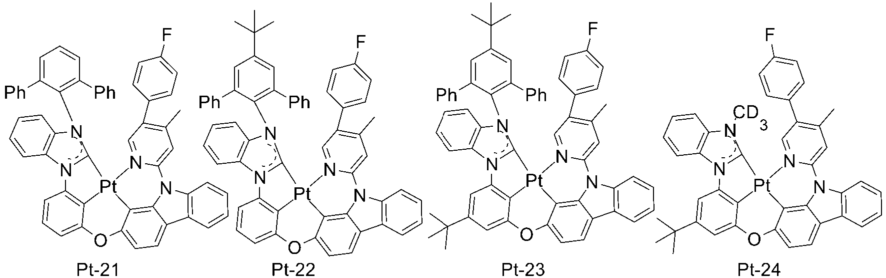

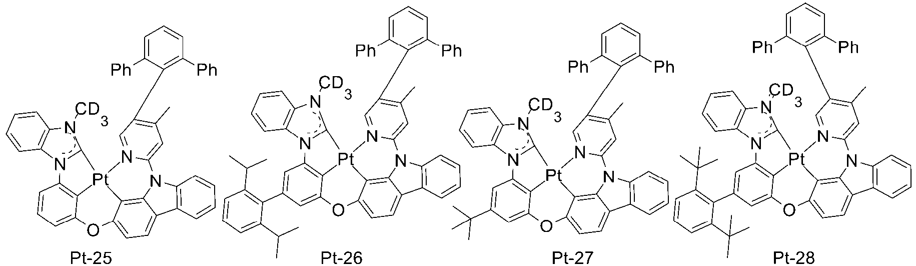

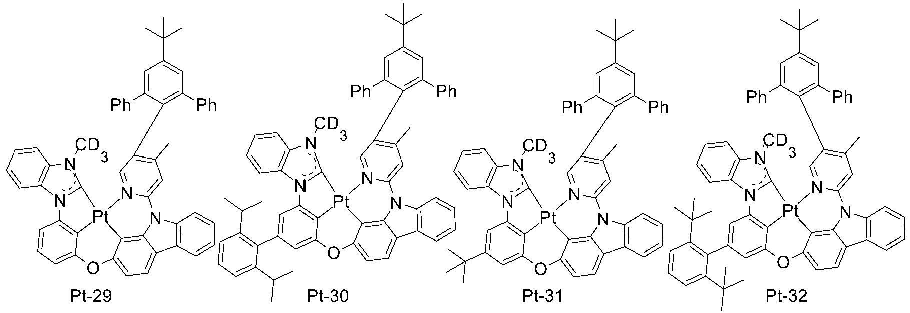

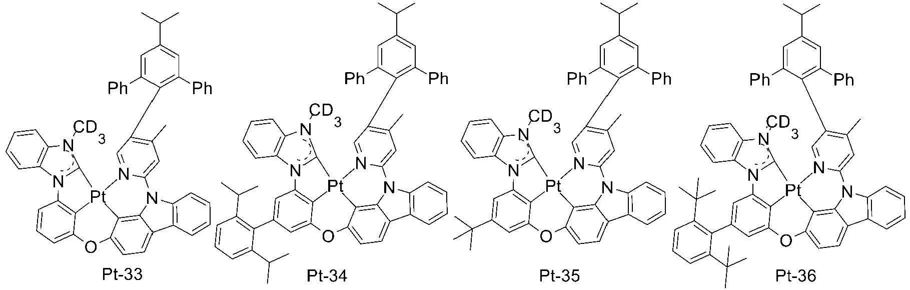

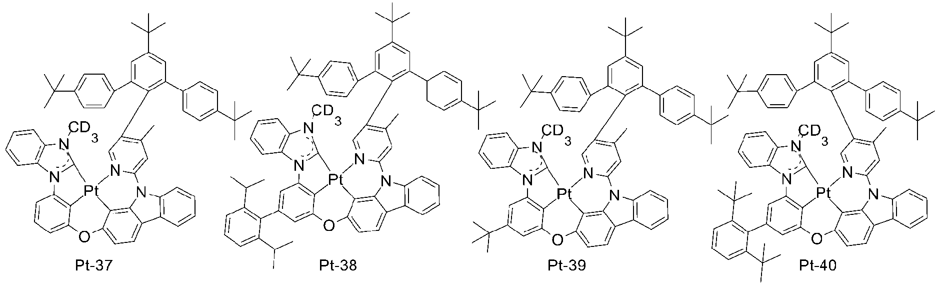

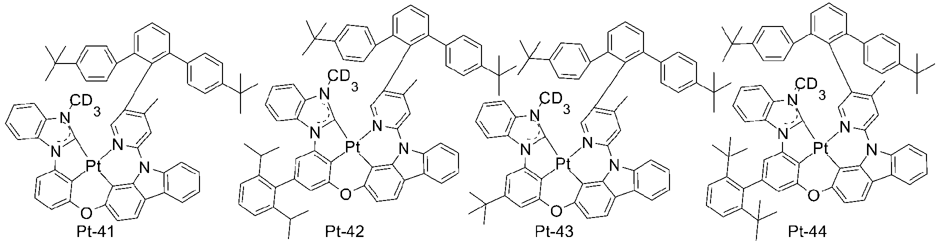

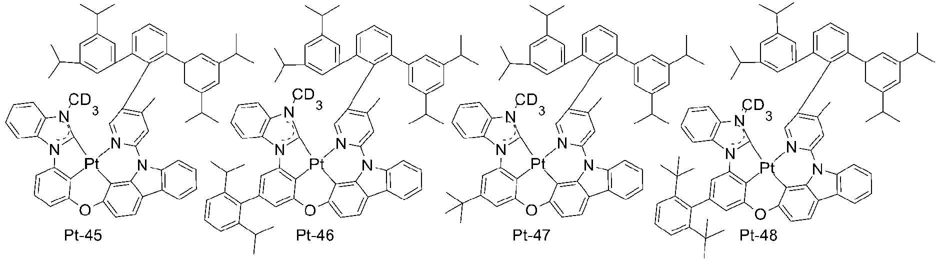

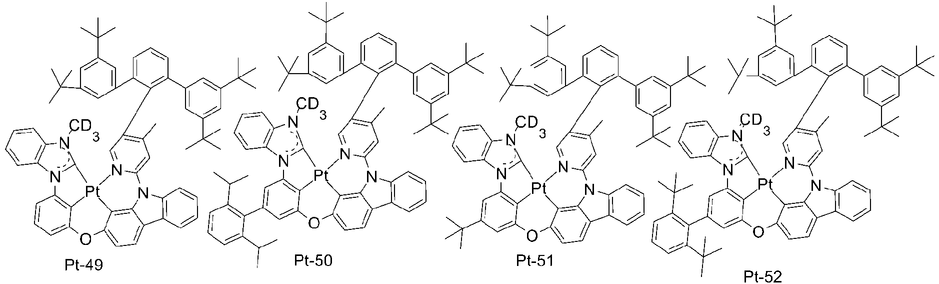

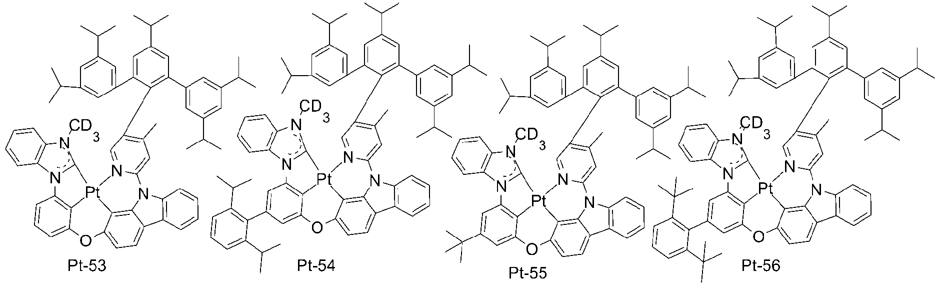

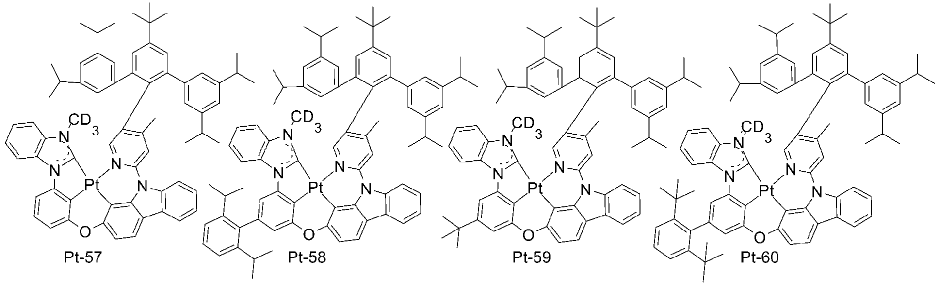

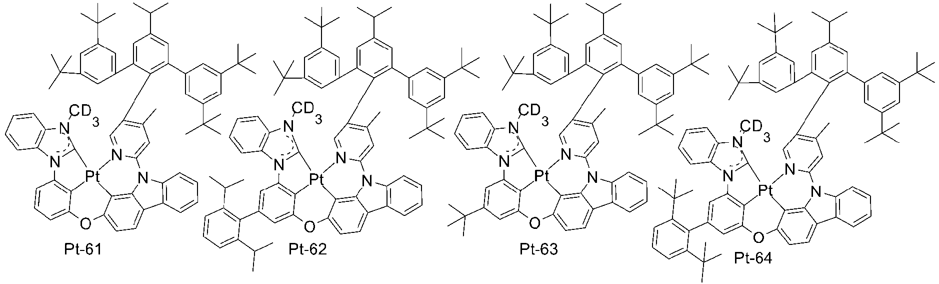

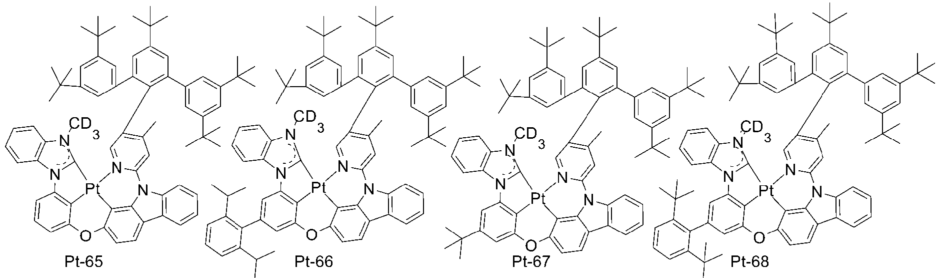

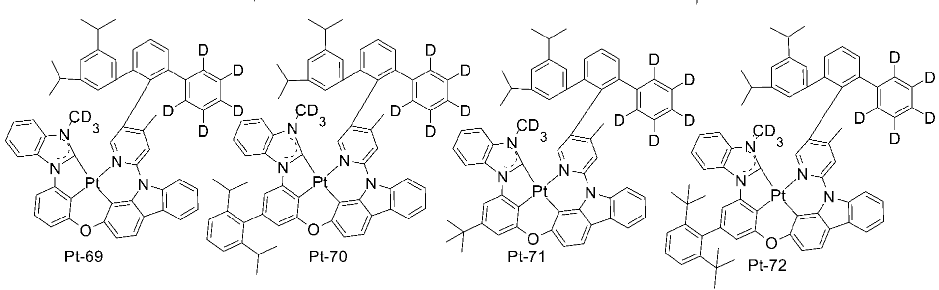

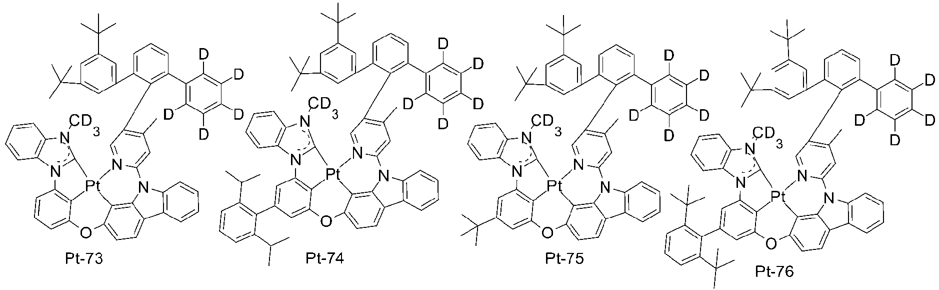

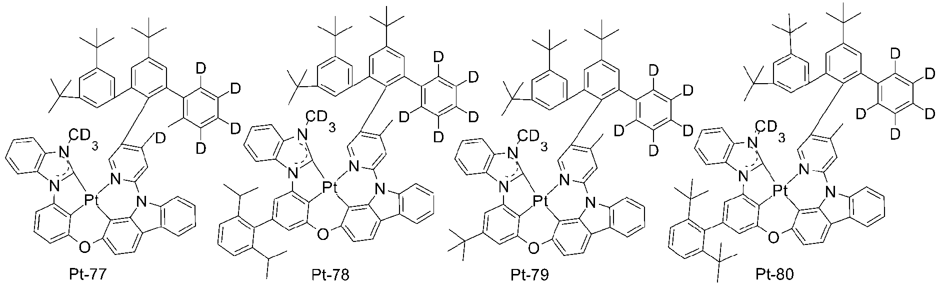

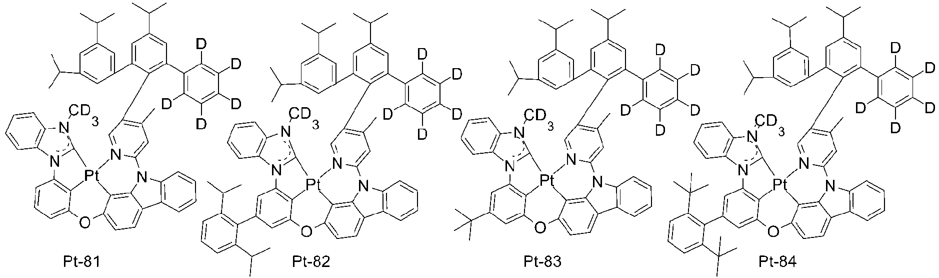

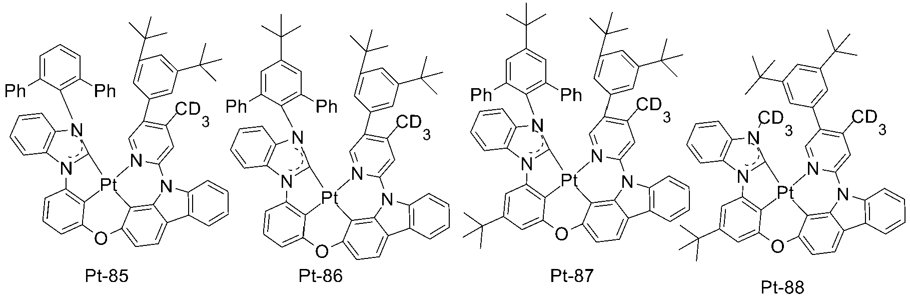

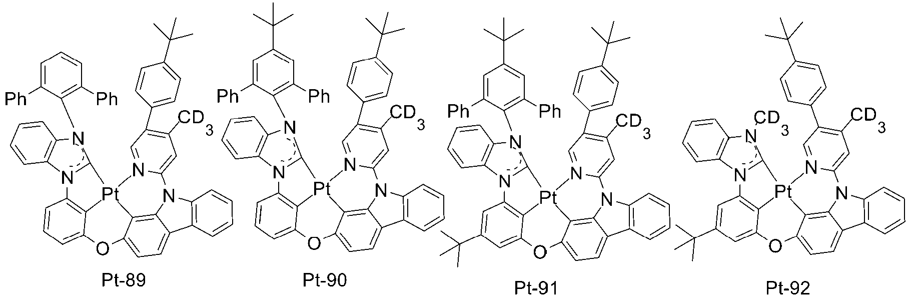

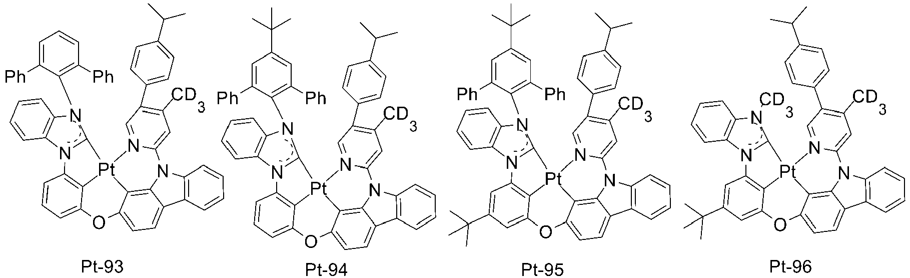

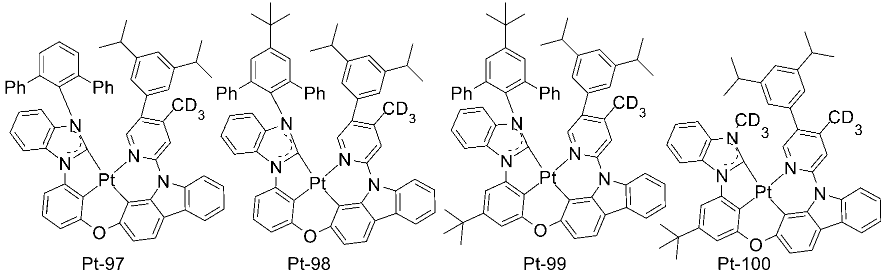

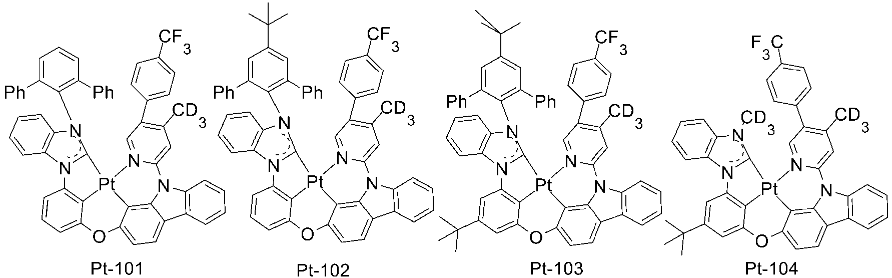

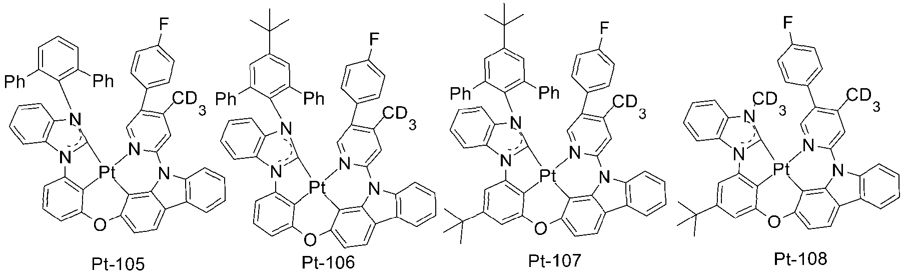

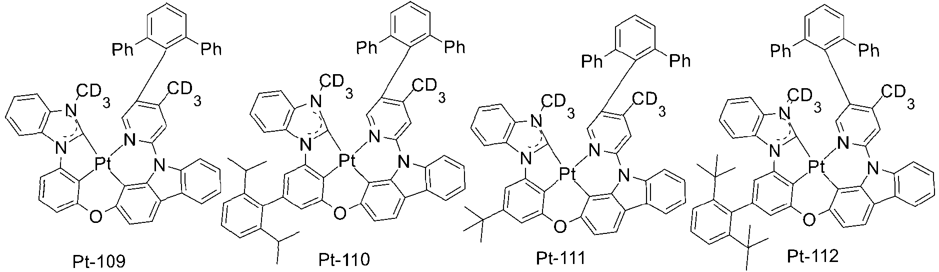

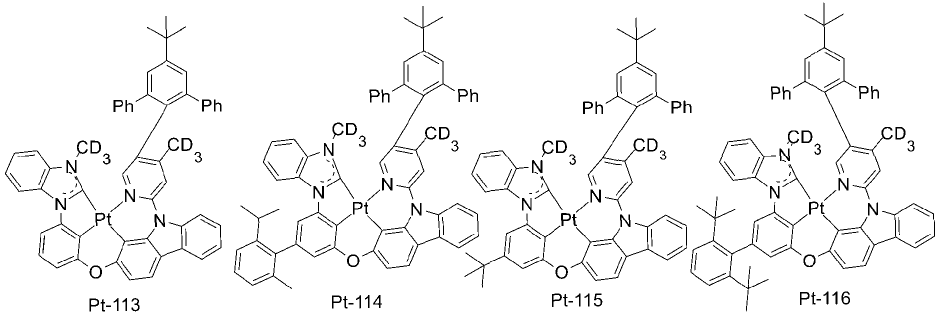

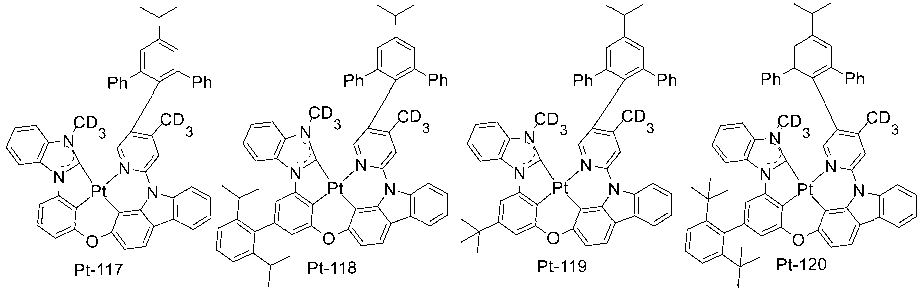

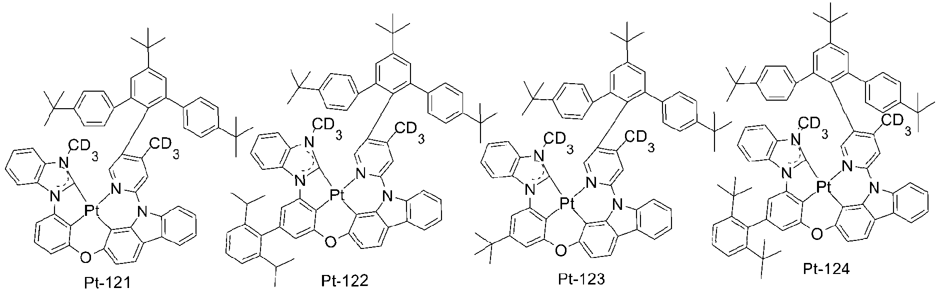

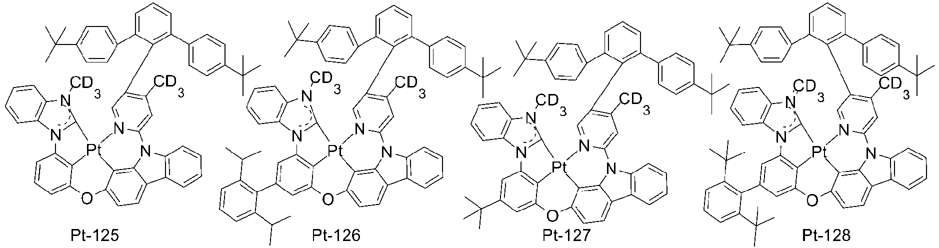

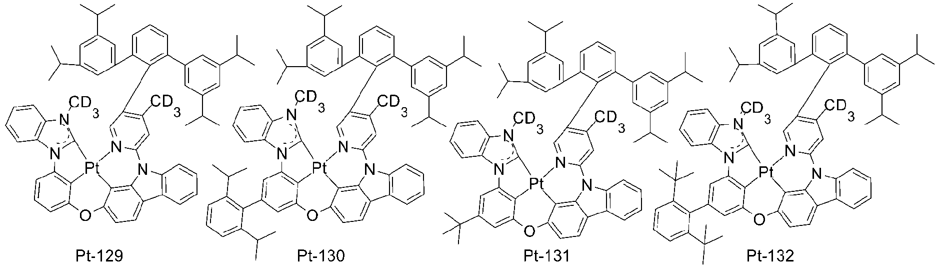

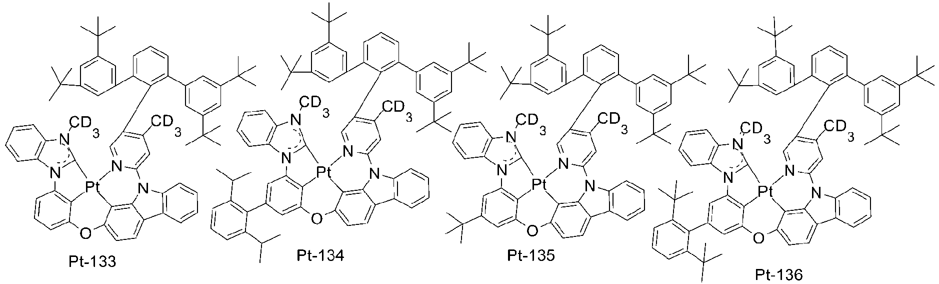

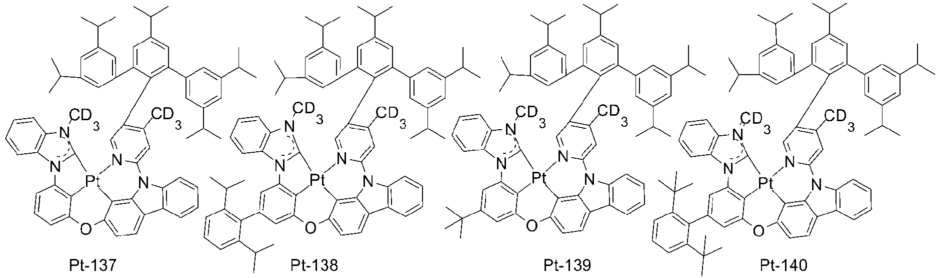

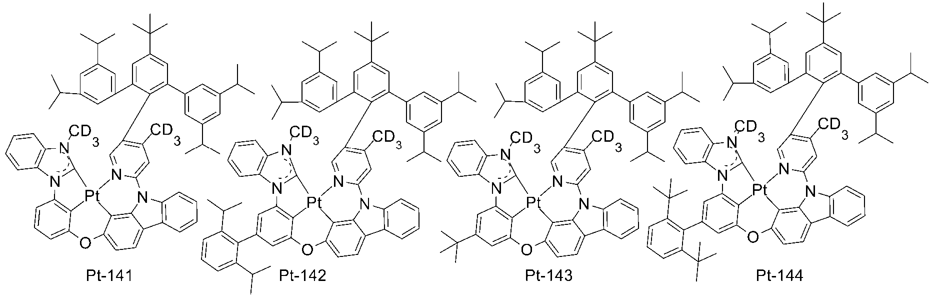

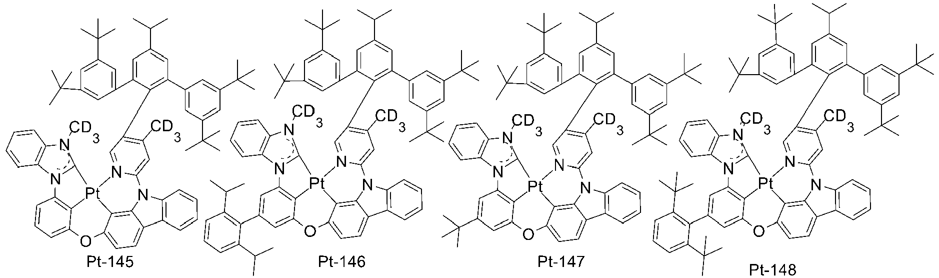

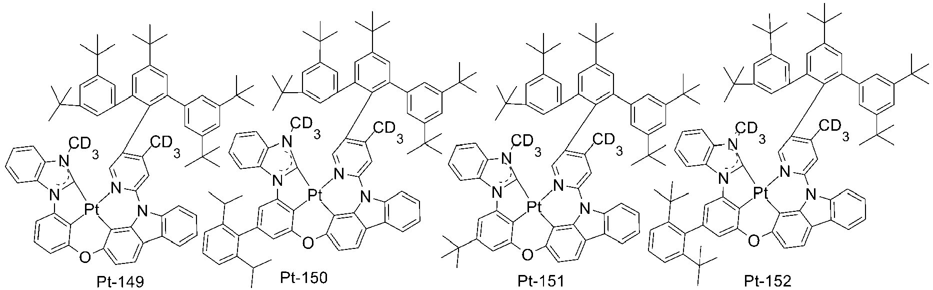

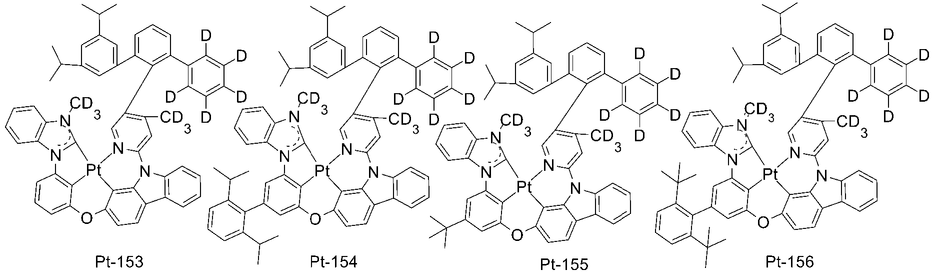

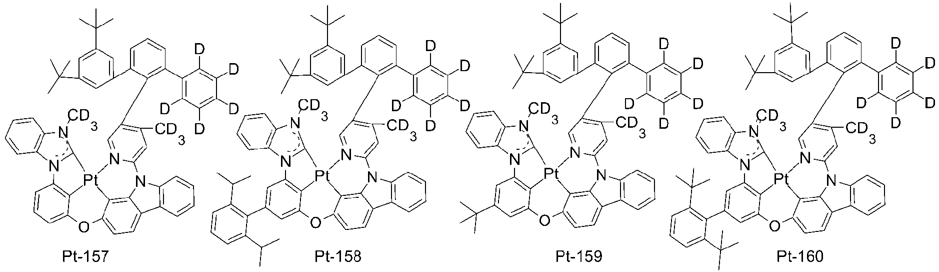

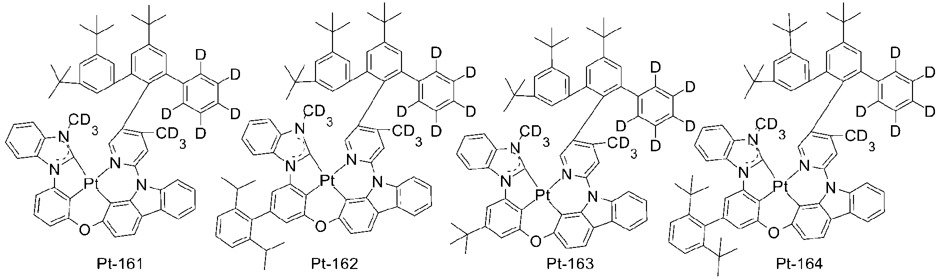

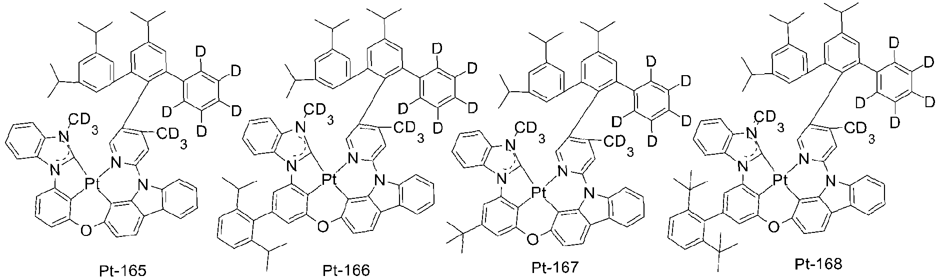

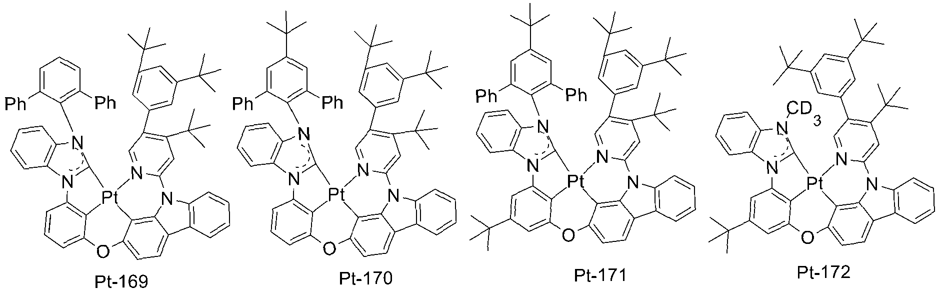

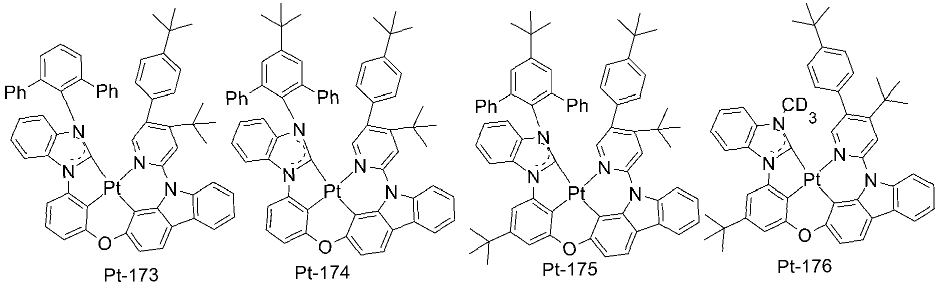

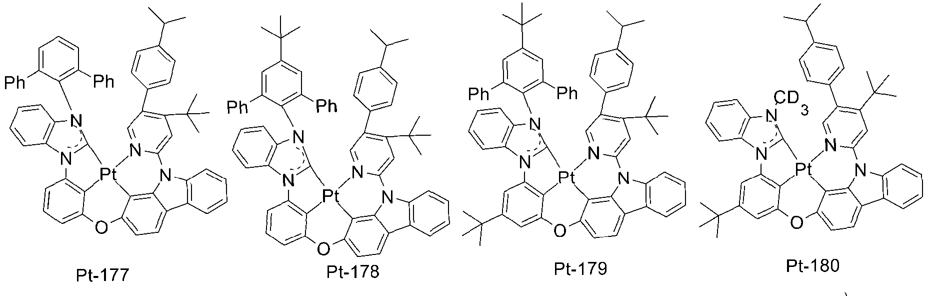

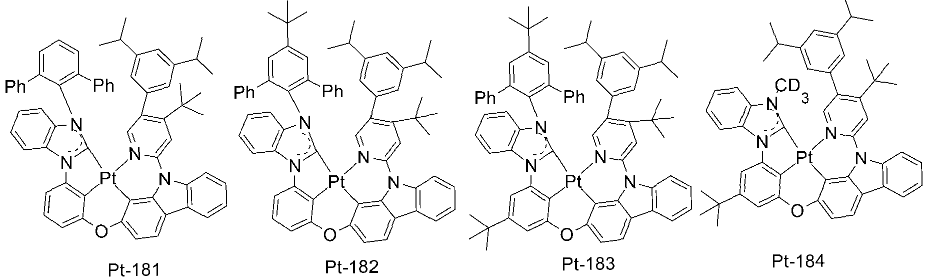

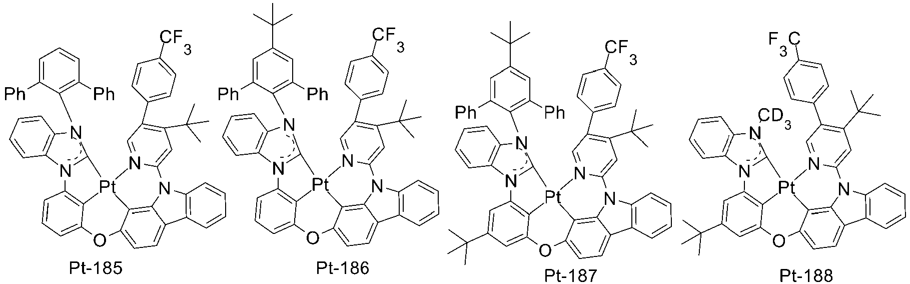

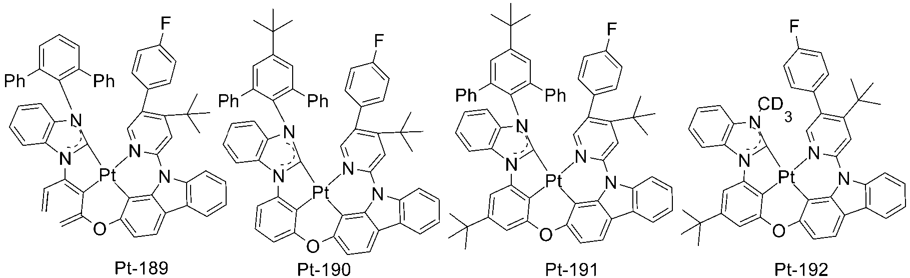

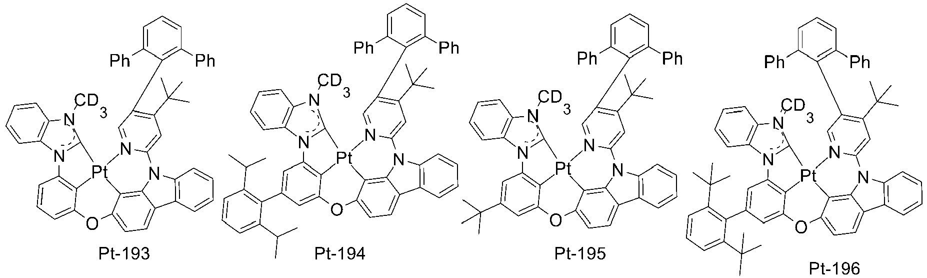

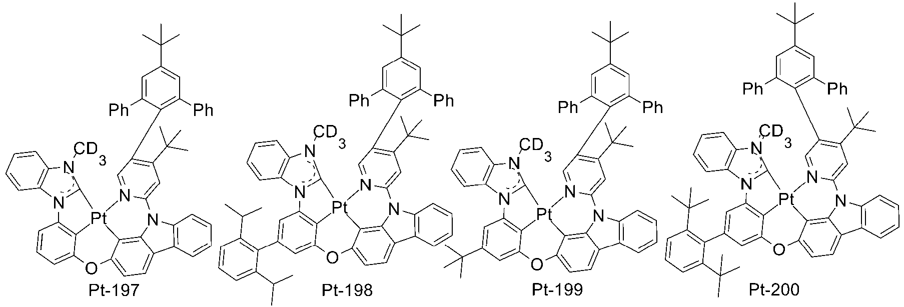

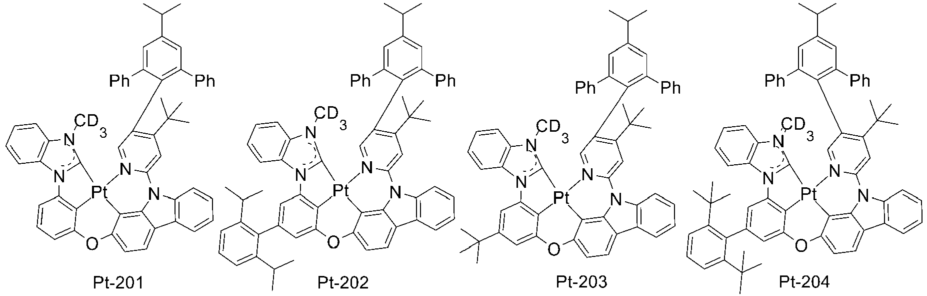

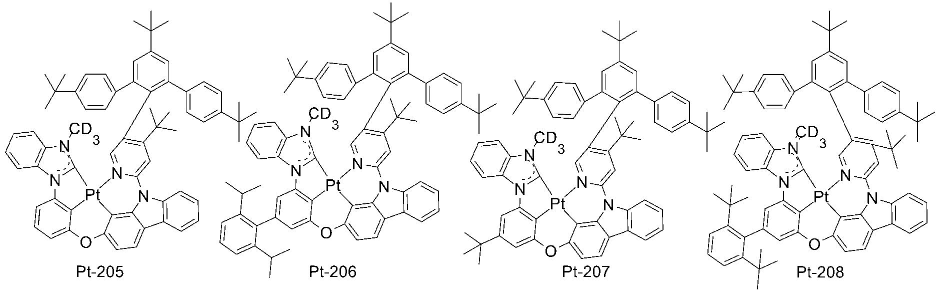

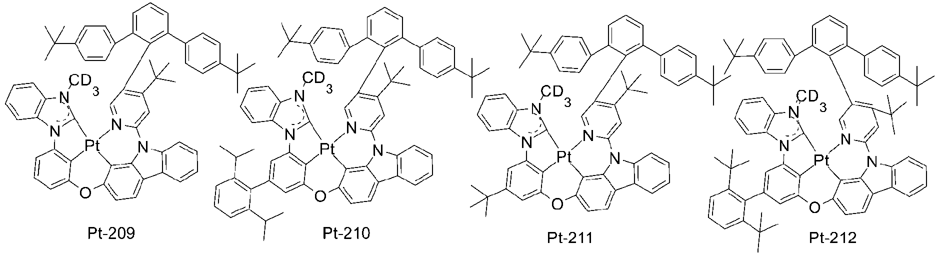

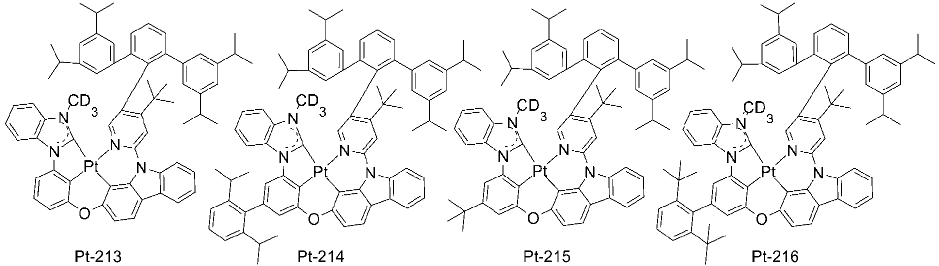

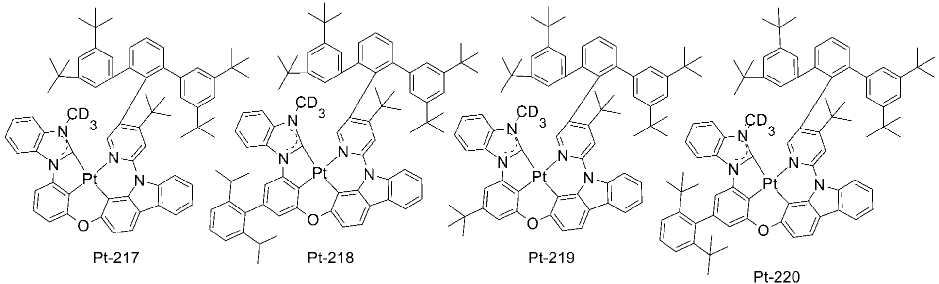

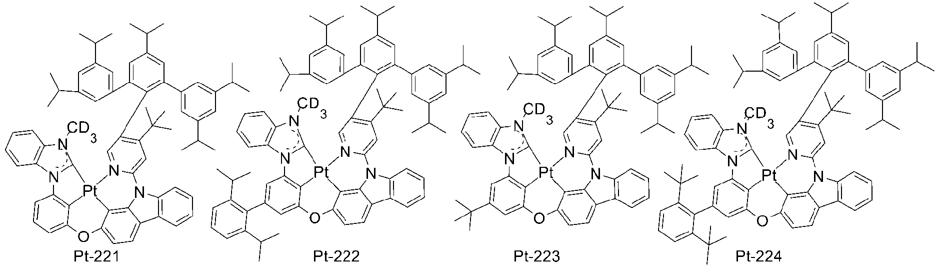

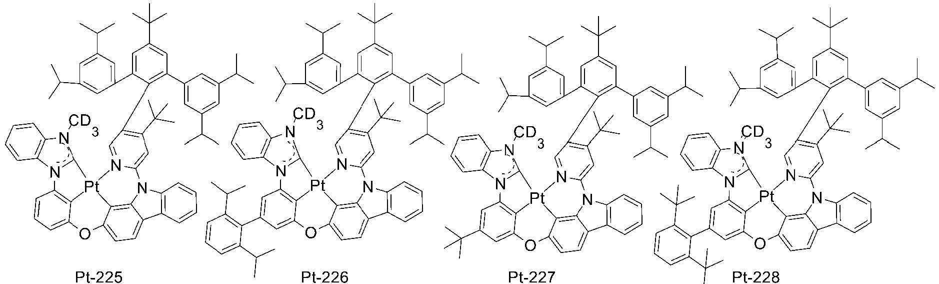

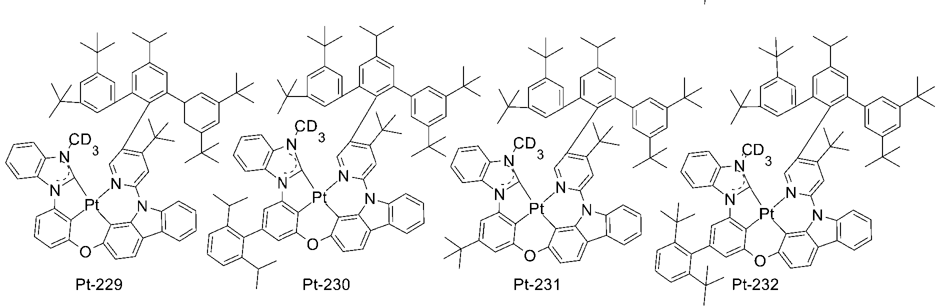

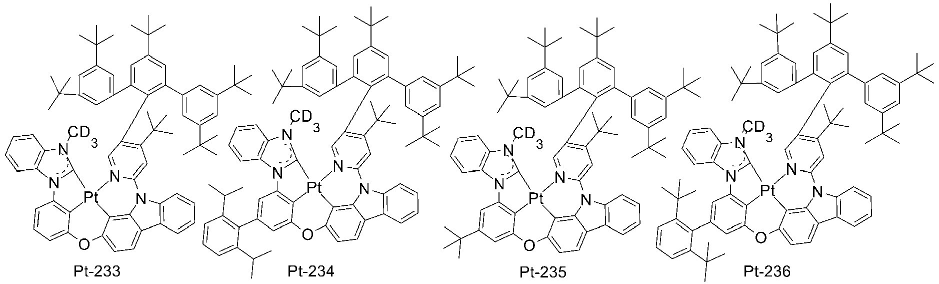

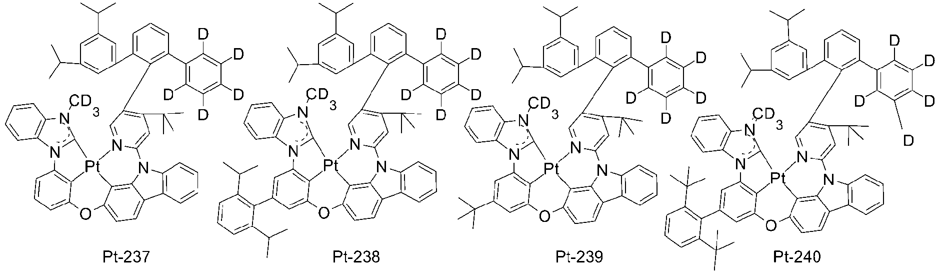

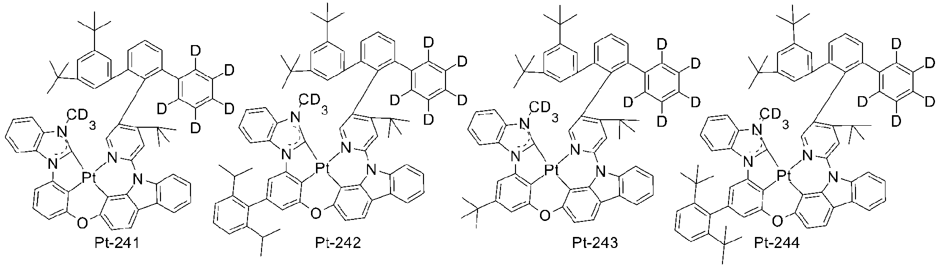

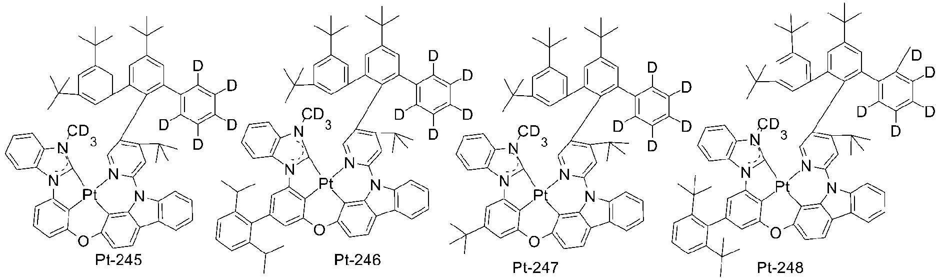

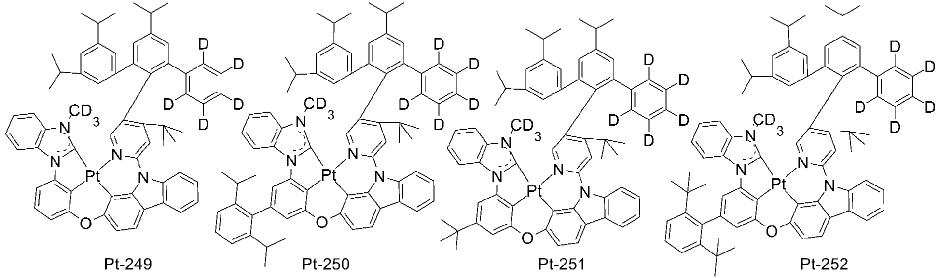

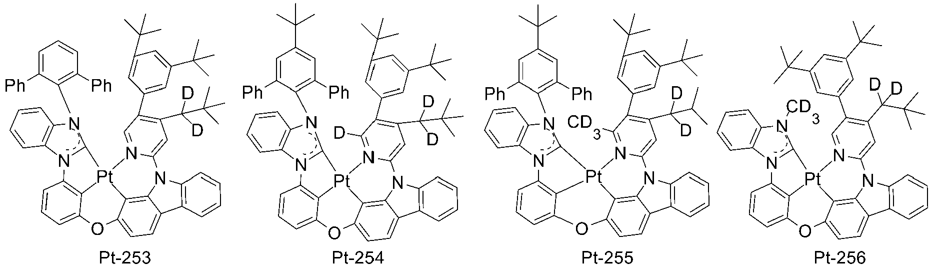

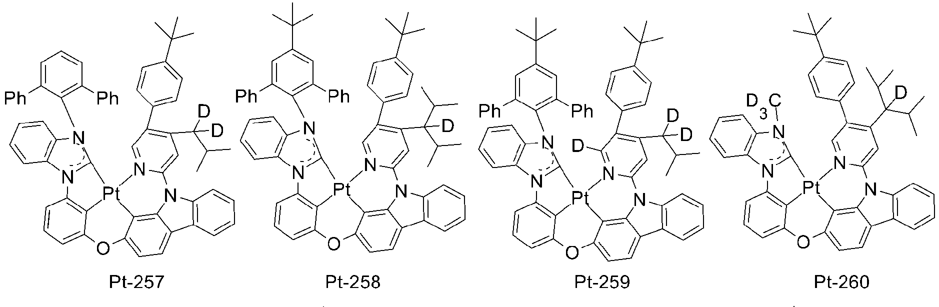

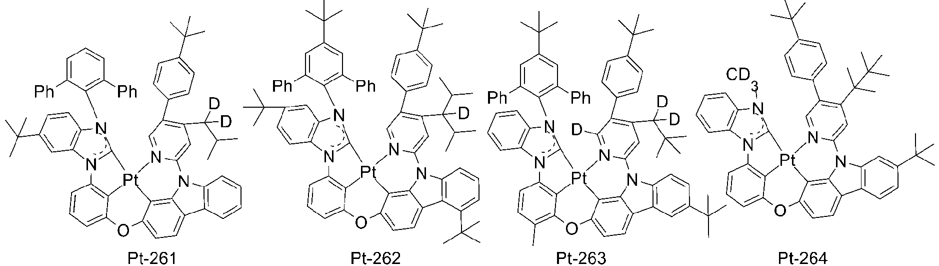

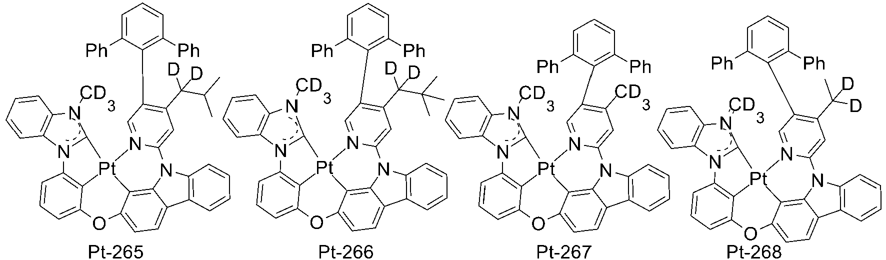

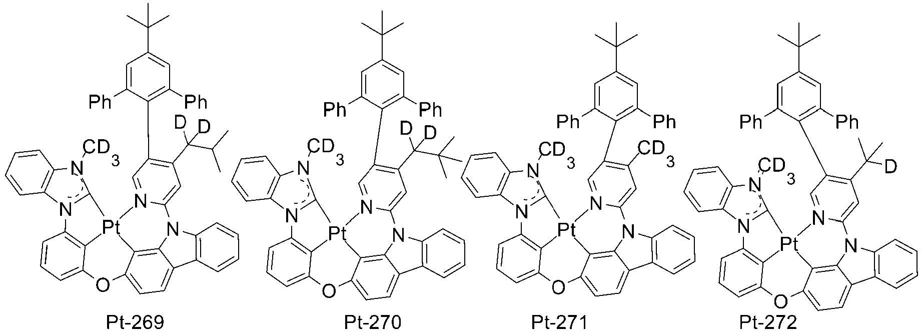

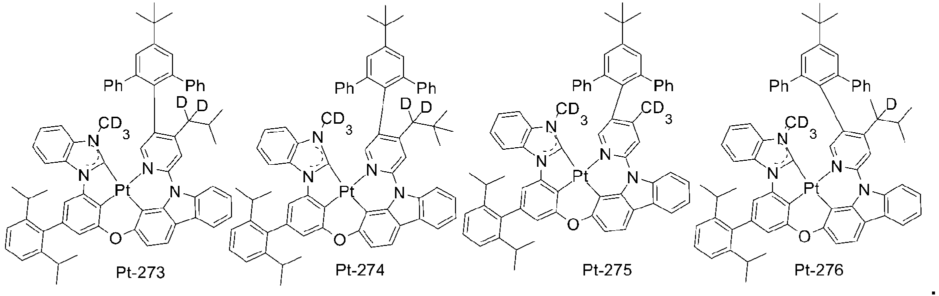

5. An application of the tetradentate cyclometalated platinum(II) complex according to any one of claims **1** to **4** in an electronic device, wherein the electronic device comprises one or more of an organic electroluminescent device, an organic integrated circuit, an organic field-effect transistor, an organic thin-film transistor, an organic light-emitting transistor, an organic solar cell, an organic optical detector, an organophotoreceptor, an organic field-quench device, a light-emitting electrochemical cell and an organic laser diode.

6. An organic electroluminescent device, **characterized in that**, the organic electroluminescent device comprises a cathode, an anode and an organic functional layer between the cathode and the anode, wherein the organic functional layer contains the tetradentate cyclometalated platinum(II) complex according to any one of claims **1** to **4.**

7. An organic electroluminescent device, **characterized in that**, the organic functional layer includes a light-emitting layer, wherein the light-emitting layer contains the tetradentate cyclometalated platinum(II) complex according to any one of claims **1** to **4.**

8. The organic electroluminescent device according to claim **7, characterized in that**, the light-emitting layer further contains a fluorescent dopant material.

9. An organic optoelectronic device, **characterized in that**, the organic optoelectronic device comprises: a substrate layer; a first electrode disposed on the substrate; an organic light-emitting functional layer disposed on the first electrode; and a second electrode disposed on the organic light-emitting functional layer, wherein the organic light-emitting functional layer contains the tetradentate cyclometalated platinum(II) complex according to any one of claims **1** to **4.**

10. The organic optoelectronic device according to claim **9, characterized in that**, the organic light-emitting functional layer further contains a fluorescent dopant material.

11. A composition, **characterized in that**, the composition contains the tetradentate platinum(II) complex according to any one of claims **1** to **4.**

12. A formulation, **characterized in that**, the formulation contains the tetradentate platinum(II) complex according to any one of claims **1** to **4.**

13. A display or lighting apparatus, **characterized in that**, the apparatus comprises at least one organic electroluminescent device each according to any one of claims **6** to **8.**
